# EUROPEAN PATENT APPLICATION

(11) **EP 2 555 260 A1**
(43) Date of publication of application: **06.02.2013**
(21) Application number: 11762800.8
(22) Date of filing: 28.03.2011
(51) Int. Cl.: H01L 33/50

(54) **LIGHT-EMITTING DEVICE**

(30) Priority: 30.03.2010 JP 2010079347
(71) Applicant: Mitsubishi Chemical Corporation, Chiyoda-ku Tokyo 100-8251 (JP)
(72) Inventor: KIJIMA, Naoto, Tokyo 194-0031 (JP); YOKOO, Toshiaki, Aoba-ku, Yokohama-shi, Kanagawa 227-8502 (JP); KATSUMOTO, Tadahiro, Aoba-ku, Yokohama-shi, Kanagawa 227-8502 (JP); KODAMA, Hiroya, Aoba-ku, Yokohama-shi, Kanagawa 227-8502 (JP); YOYASU, Fumiko, Aoba-ku, Yokohama-shi, Kanagawa 227-8502 (JP)
(74) Representative: HOFFMANN EITLE
(86) International application number: PCT/JP2011/057683
(87) International publication number: WO 2011/122576

(57) **Abstract**

An object of the present invention is to provide a light emitting device which increases the emission efficiency of phosphor by reducing self-absorption of light by phosphor and by reducing absorption of fluorescent light by an encapsulating resin, and which increases the efficiency of light extraction from the phosphor layer by preventing light scattering caused by the phosphor.

The above object was achieved by a light emitting device comprising a semiconductor light emitting element and a phosphor layer wherein the phosphor layer was made dense by setting specific values for particle distribution of phosphor contained in the phosphor layer and for the fill rate of the phosphor contained in the phosphor layer.

## Description

### TECHNICAL FIELD

The present invention relates to a light emitting device and, more particularly, to a light emitting device exhibiting high emission efficiency and including a phosphor layer of a high light extraction efficiency.

### BACKGROUND ART

A light emitting device which uses a semiconductor light emitting element holds a phosphor in an encapsulating resin which covers the light emitting element and color-converts, by means of the phosphor, the light which is irradiated from the light emitting element before irradiating the light to the outside. For example, Patent Document 1 discloses a light emitting device which comprises a phosphor layer containing a phosphor and an encapsulating resin and with which breakage of bonding wires electrically connecting the semiconductor light emitting element can be prevented by setting specific values for the film thickness of the phosphor layer and for the volume packing ratio of the phosphor contained in the phosphor layer.

Japanese Patent Application Laid-open No. 2008-251664

### DISCLOSURE OF THE INVENTION

However, the light emitting element according to Patent Document 1 is confronted by the problem that, in using a phosphor layer of a large thickness, in the fluorescent light emitted from the phosphor which is disposed in a position close to the semiconductor light emitting element also in the phosphor layer, there is a large proportion of light which is self-absorbed by phosphor of the same type until the emission surface is reached or there is a large proportion of light which is absorbed by the encapsulating resin until the emission surface is reached and, as a result, the emission efficiency of the phosphor layer is low (first problem).
The light emitting element according to Patent Document 1 is confronted by the problem that, in using a phosphor layer of a large thickness, in the fluorescent light emitted from the phosphor which is disposed in a position close to the semiconductor light emitting element also in the phosphor layer, there is a large proportion of light which is scattered by other phosphor until the emission surface is reached and, as a result, light extraction efficiency of the phosphor layer is low (second problem).
Further, if the phosphor layer comprises a mixture of a plurality of phosphors of different emission colors, a phenomenon arises whereby phosphor of another type absorbs the fluorescent light emitted by a certain type of phosphor and so-called cascade excitation arises, and the light emission efficiency of the phosphor layer is low (third problem).
In addition, as per the light emitting device according to Patent Document 1, if the phosphor layer is configured to directly cover the semiconductor light emitting element, as the light output of the semiconductor light emitting element increases, not only does the temperature of the semiconductor light emitting element rise, but also the temperature of the phosphor rises due to the heat generated through loss at the time of color conversion of the phosphor and, as a result, the emission efficiency of the semiconductor light emitting element and the phosphor layer is low (fourth problem).
Further, there is a problem in that, if a light emitting device is configured using a semiconductor light emitting element which emits light from the ultraviolet light range to the near-ultraviolet light range and a phosphor which emits visible light by being excited by the light from the semiconductor light emitting element, when, in the light from the semiconductor light emitting element, there is a large proportion of light which is output as is without being converted to visible light in the phosphor layer, the emission efficiency of the phosphor layer is low (fifth problem).
In addition, if a light emitting device is configured using a semiconductor light emitting element which emits light from the ultraviolet light range to the near-ultraviolet light range and a phosphor which emits visible light by being excited by the light from the semiconductor light emitting element, when, in the visible light emitted from the phosphor layer, there is a large proportion of light which is emitted on the semiconductor light emitting element side, the emission efficiency of the light emitting device is low (sixth problem).
Furthermore, as per the light emitting device according to Patent Document 1, if the phosphor layer is configured to directly cover the semiconductor light emitting element, there is a problem in that the emission spectrum of the light emitting device cannot be easily changed unless the positions of the phosphor layer and semiconductor light emitting element can be moved or exchanged (seventh problem).

The inventors undertook intensive research to solve the foregoing first and second problems, directing their attention toward the configuration of the phosphor layer provided in the light emitting device. Further, the inventors discovered that, by using a thin, delicate phosphor layer for which specific values have been set for the thickness of the phosphor layer and the packing ratio of the phosphor contained in the phosphor layer, the self absorption of light by the phosphors can be reduced and the emission efficiency of the phosphor can be increased, and that light scattering caused by the phosphor can be prevented, thereby raising the efficiency of light extraction from the phosphor layer, and thus completed the invention. The present invention is a light emitting device which is configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element by being excited by the light emitted by the semiconductor light emitting element,
(iii) the phosphor layer includes the phosphor at a volume packing ratio of at least 15%, and
(iv) a ratio (Dᵥ/Dₙ) between a volumetric basis average particle diameter Dᵥ and a number mean diameter Dₙ of the phosphor in the phosphor layer is 1.2 or more and 25 or less.

Further, in a preferred aspect, the phosphor layer has a thickness which is two or more times and 10 or less times the volume median diameter D₅₀ᵥ of the phosphor.

Further, in a preferred aspect, the volume median diameter D₅₀ᵥ of the phosphor is 2 µm or more and 30 µm or less.

In addition, the present invention is a light emitting device configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element, by being excited by the light emitted by the semiconductor light emitting element,
(iii) the phosphor layer has a thickness of two or more times and ten or less times a volume median diameter D₅₀ᵥ of the phosphor, and
(iv) a ratio (Dᵥ/Dₙ) between a volumetric basis average particle diameter Dᵥ and a number mean diameter Dₙ of the phosphor in the phosphor layer is 1.2 or more and 25 or less.

Furthermore, in a preferred aspect, a difference between a maximum thickness and a minimum thickness of the phosphor layer is no more than a volume median diameter D₅₀ᵥ of the phosphor layer.

In addition, the present invention is a light emitting device which is configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element by being excited by the light emitted by the semiconductor light emitting element,
(iii) a ratio (Dᵥ/Dₙ) between a volumetric basis average particle diameter Dᵥ and a number mean diameter Dₙ of the phosphor in the phosphor layer is 1.2 or more and 25 or less, and
(iv) a difference between a maximum thickness and a minimum thickness of the phosphor layer is no more than a volume median diameter D₅₀ᵥ of the phosphor layer.

Further, in a preferred aspect, the phosphor layer contains a binder resin.

In addition, in a preferred aspect, the phosphor has overlapping wavelength ranges between an emission wavelength range in an emission spectrum and an excitation wavelength range in an excitation spectrum.

Furthermore, in a preferred aspect, the phosphor includes a first phosphor capable of emitting first light of a longer wavelength than the light emitted by the semiconductor light emitting element, by being excited by the light emitted by the semiconductor light emitting element, and a second phosphor which is capable of emitting second light of a longer wavelength than the first light, by being excited by the light emitted by the semiconductor light emitting element.

Further, in a preferred aspect, the second phosphor is a phosphor which is capable of emitting second light of a longer wavelength than the first light by being excited by the first light.

In addition, in a preferred aspect, a difference between a value of the D₅₀ᵥ of the first phosphor and a value of the D₅₀ᵥ of the second phosphor is at least 1 µm.

Furthermore, in order to solve the third problem, in a preferred aspect, the phosphor layer includes a first light emitting member and a second light emitting member, wherein
(i) the first light emitting member contains the first phosphor,
(ii) the second light emitting member contains the second phosphor, and
(iii) the first light emitting member and the second light emitting member in the phosphor layer are formed as separate members in a direction perpendicular to a thickness direction of the phosphor layer.

Further, in order to solve the fourth problem, in a preferred aspect, the light emitting device is configured such that a distance between the semiconductor light emitting element and the phosphor layer is 0.1 mm or more and 500 mm or less.

In addition, in order to solve the fifth problem, in a preferred aspect, the light emitting device comprises, on the light emission side of the light emitting device of the phosphor layer, a bandpass filter which reflects at least a portion of the light emitted by the semiconductor light emitting element and transmits at least a portion of the light emitted by the phosphor.

Further, in order to solve the sixth problem, in a preferred aspect, the light emitting device comprises, on the semiconductor light emitting element side of the phosphor layer, a bandpass filter which transmits at least a portion of the light emitted by the semiconductor light emitting element and reflects at least a portion of the light emitted by the phosphor.

Further, in order to solve the seventh problem, in a preferred aspect, the phosphor layer has an area A and an area B with different emission spectra, and the light emitting device is configured such that a proportion of light which is irradiated onto the area A and area B from the semiconductor light emitting element can be adjusted by the phosphor layer or the semiconductor light emitting element moving in a direction perpendicular to a thickness direction of the phosphor layer.

The present invention enables the provision of a light emitting device which increases the emission efficiency of phosphor by reducing self-absorption of light by phosphors and the absorption of light by an encapsulating resin, and which increases the efficiency of light extraction from the phosphor layer by preventing light scattering caused by the phosphor.

### BRIEF DESCRIPTION OF THE DRAWINGS

Fig. 1 is a conceptual diagram showing an embodiment of a light emitting device of the present invention;
Fig. 2 is a conceptual diagram showing an embodiment of a light emitting device of the present invention;
Fig. 3 is a conceptual diagram showing an embodiment of a phosphor layer used in the light emitting device of the present invention;
Fig. 4 is a conceptual diagram showing an embodiment of a light emitting device of the present invention;
Fig. 5 is a conceptual diagram showing an embodiment of a light emitting device of the present invention;
Fig. 6 is a conceptual diagram showing a plurality of embodiments of the light emitting device of the present invention;
Fig. 7-1 is an enlarged view of an interface between light-emitting members present in the phosphor layer of the light emitting device of the present invention;
Fig. 7-2 is an enlarged view of an interface between light-emitting members present in the phosphor layer of the light emitting device of the present invention;
Fig. 7-3 is an enlarged view of an interface between light-emitting members present in the phosphor layer of the light emitting device of the present invention;
Fig. 8 shows a plurality of examples of phosphor layer patterns used in the light emitting device of the present invention;
Fig. 9 shows a plurality of examples of phosphor layer patterns used in the light emitting device of the present invention;
Fig. 10 shows one example of the pattern of a phosphor layer pattern used in the light emitting device of the present invention;
Fig. 11 shows a conceptual diagram of the light emitting device of Example 1;
Fig. 12 is a graph showing the relationship between the total luminous flux and the volume packing ratio of the phosphor in the phosphor layer of the light emitting device of Example 1; and
Fig. 13 is a graph showing the relationship between the total luminous flux and the phosphor layer thickness of the light emitting devices of Examples 5 to 12.

### BEST MODE FOR CARRYING OUT THE INVENTION

The light emitting device of the present invention is a light emitting device which comprises a semiconductor light emitting element and a phosphor layer. Further, the light emitting device normally comprises a package for holding the semiconductor light emitting element.

### <1. Phosphor layer>

### <1-1. Characteristics of phosphor layer>

The phosphor layer which the light emitting device of the present invention comprises is preferably a phosphor layer which is formed densely and comprises phosphor.

By forming a dense phosphor layer, the light from the semiconductor light emitting element which is not excited by the phosphor in the phosphor layer can be reduced and the emission efficiency can be increased. In addition, in the case of a phosphor layer whereon an encapsulating resin is laid, the amount of encapsulating resin used can be reduced by densely filling the phosphor, enabling light absorption by the encapsulating resin to be reduced and the emission efficiency to be increased.
As disclosed in Japanese Patent Application Laid-open Nos. 2007-194147 and 2008-179781, in a CCFL application, phosphor which is capable of being excited upon absorbing ultraviolet rays in a vacuum has conventionally been filled densely. However, it is known that, in an LED application, as in a CCFL application, when phosphor which is capable of being excited upon absorption of near-ultraviolet to visible light is filled densely, due to the reduction in the distance between the phosphor particles, there in an increase in the reliability with which self-absorption or cascade excitation of the light emitted by certain phosphor particles occurs as a result of other phosphor particles existing nearby, and, as a result, a reduction in emission efficiency. It was therefore considered preferable to not densely fill the phosphor in the LED application. However, when the inventors undertook an investigation, surprisingly, it was found that a reduction in the emission efficiency due to light absorption by the encapsulating resin had a greater effect than a drop in the emission efficiency due to self absorption or cascade excitation, and it was understood that reducing the amount of the encapsulating resin by filling the phosphor more densely favored an increase in the emission efficiency.
A dense phosphor layer can be expressed in terms of the volume packing ratio of the phosphor in the phosphor layer and, in the present invention, the emission efficiency can be increased if the volume packing ratio of the phosphor in the phosphor layer is at least 15%. If the volume packing ratio is less than 15%, there is an increase in the light from the semiconductor light emitting element which is not excited by the phosphor in the phosphor layer and, in the phosphor layer comprising the encapsulating resin, since the amount of encapsulating resin used in relation to the phosphor is excessive, the proportion of light absorbed by the encapsulating resin increases, thereby lowering the emission efficiency. The volume packing ratio is preferably at least 20%, more preferably at least 40%, and even more preferably at least 50%. There is no particular limit on the upper limit, and although a value greater than the most dense filling at about 74% is hardly normal, this value may also be exceeded if, for example, the particle diameter is large and particles of different sizes are combined.

As described earlier, the phosphor can be filled more densely when there is distribution in the particle diameter of the phosphor than when the particle diameter of the phosphor is uniform. Further, as illustrated by the graph of Fig. 6.3 on page 268 of "The Structure and Rheology of Complex Fluids" (Ronald G. Larson Oxford University Press 1999), for example, providing distribution in the particle diameter by mixing particles of different diameters, rather than a dispersion fluid formed by dispersing particles of a single diameter in a medium, tends to produce to a lower viscosity even when there is a high concentration of particles in the dispersion fluid and more particularly, tends to produce a lower viscosity as the range of the particle diameter distribution widens. Hence, an arrangement where distribution is used in the phosphor particle diameter rather than a uniform particle diameter for the phosphor yields favorable handling properties during fabrication of the phosphor layer, for example making application easy if fabrication is performed using screen printing. Indicators for the extent of the particle diameter distribution include the ratio (Dᵥ/Dₙ) between a volumetric basis average particle diameter Dᵥ and a number mean diameter Dₙ of the phosphor. In the invention of this application, Dᵥ/Dₙ is preferably at least 1.2, more preferably at least 1.35, even more preferably at least 1.5, particularly preferably at least 1.8, and most preferably at least 2.0. If Dᵥ/Dₙ is too small, it is hard to densely fill the phosphor and a process to make the particle uniform is then required, for example a sieving process, which tends to lead to high costs. Meanwhile, Dᵥ/Dₙ is preferably no more than 25, more preferably no more than 15, still more preferably no more than 10, even more preferably no more than 5, particularly preferably no more than 3, and most preferably no more than 2.5. If Dᵥ/Dₙ is too large, phosphor particles whose weight greatly varies are present and there tends to be a non-uniform distribution of phosphor particles in the phosphor layer.
Note that by setting Dᵥ/Dₙ in the foregoing range, a dense phosphor layer can be produced and, more particularly, the volume packing ratio of the phosphor in the phosphor layer can be easily set at no less than the lower limit value and the emission efficiency can be increased. The viscosity when mixing with the binder resin due to the distribution in the particle diameter can be reduced, and hence the thickness of the phosphor layer can easily be made uniform, whereby color inconsistencies can be suppressed.
Further, Dᵥ, Dₙ above can be calculated from a frequency-based particle size distribution curve obtained by measurement using a particle size distribution measurement device based on the laser diffraction and scatter method, described subsequently.

The phosphor layer of the present invention may contain only phosphor of a single type or may contain phosphor of a plurality of types. If the phosphor layer comprises only phosphor of a single type, Dᵥ/Dₙ above represents the particle ratio of a single type of phosphor. If, on the other hand, the phosphor layer comprises red, green and blue phosphor, for example, Dᵥ/Dₙ above represents the particle ratio of the phosphor mixture obtained by mixing each of these phosphors.

In addition, in a case where a phosphor mixture in which a plurality of phosphors with a different D₅₀ᵥ are mixed is used, there may be two or more peaks in the frequency-based particle size distribution curve for the phosphor mixture. In this case, the Dᵥ/Dₙ of the phosphor mixture can easily be set in the above range and, if mixed with a binder resin, the viscosity can be reduced, and therefore it tends to be possible to suppress the thickness of the phosphor layer at the time the layer is applied by means of screen printing or the like.

In the present invention, the volume packing ratio is obtained by (1) finding the volume of the phosphor layer by measuring the thickness and surface area of the phosphor layer, (2) measuring the weight of the phosphor contained in the phosphor layer by measuring the weight after removing the encapsulating resin and binder from the phosphor layer, and calculating the volume by using that phosphor specific gravity, and (3) comparing these values.

Furthermore, in order to produce a dense phosphor layer, the layer density of the phosphor layer is preferably at least 1.0 g/cm³ and more preferably at least 2.0 g/cm³. If the layer density is smaller than 1.0 g/cm³, the proportion of material other than the phosphor (for example gaps and binder and so on) in the phosphor layer is excessive and the light of the semiconductor light emitting element which is not excited by the phosphor increases.

The particle diameter of the phosphor can be suitably selected according to the method of applying the phosphor as long as the foregoing requirements for the ratio (Dᵥ/Dₙ) between the volumetric basis average particle diameter Dᵥ of the phosphor and the number mean diameter Dₙ are fulfilled, and normally the volume median diameter D₅₀ᵥ is preferably at least 2 µm and more preferably at least 5 µm. Furthermore, a volume median diameter D₅₀ᵥ of no more than 30 µm is preferably used, more preferably no more than 20 µm. Here, the volume median diameter D₅₀ᵥ is defined as the particle diameter with a volumetric basis relative particle amount of 50% when a sample is measured and the particle distribution (cumulative distribution) is determined by using a particle distribution measurement device which is based on the laser diffraction and scatter method. Measurement methods include, for example, placing the phosphor in ultrapure water, using an ultrasonic nano-dispersion device (made by Kaijo Corporation) to set the frequency at 19 KHz, setting the intensity of the ultrasonic waves at 5 W, and, after ultrasonic-dispersing the sample for twenty five seconds, using a flow cell for adjustment to an 88% to 92% transmittance and, after checking that there is no particle cohesion, performing measurement in a 0.1 µm to 600 µm particle range by means of a laser diffraction particle distribution measurement device (LA-300, made by Horiba, Ltd). Further, in the foregoing method, if the phosphor particles are subjected to cohesion, a dispersant may be added, for example, the phosphor may be placed in an aqueous solution containing 0.0003% by weight of Tamol (made by BASF) or the like, and similarly to the foregoing method, measurement may be performed after dispersion using ultrasonic waves.

Furthermore, by making the phosphor layer thin, the self-absorption of light by the phosphors can be reduced and light scattering by the phosphor can be reduced. According to the present invention, by setting the thickness of the phosphor layer at preferably between 2 and 10 times the volume median diameter of the phosphor contained in the phosphor layer, self-absorption of light by the phosphors can be reduced and light scattering by the phosphor can be reduced. If the thickness of the phosphor layer is too thin, the excited light from the semiconductor light emitting element is not sufficiently converted in the phosphor layer and hence the intensity of the output light tends to fall. More preferably, the thickness of the phosphor layer is at least three times the median diameter of the phosphor and particularly preferably at least four times the median diameter. On the other hand, if the thickness of the phosphor layer is too thick, there is an increase in the self-absorption of light by the phosphor and the intensity of the output light tends to drop. More preferably, the thickness of the phosphor layer is no more than nine times the median diameter of the phosphor, particularly preferably no more than eight times the median diameter, more preferably no more than seven times the median diameter, even more preferably no more than six times the median diameter, and most preferably no more than five times the median diameter. The thickness of the phosphor layer can be measured by cutting the phosphor layer in the thickness direction and observing the cross section using a SEM or other electron microscope. Furthermore, the thickness of the phosphor layer can be measured by measuring the thickness obtained by combining the phosphor layer with a substrate to which the phosphor layer is applied using a micrometer and then measuring the thickness of the substrate once again using the micrometer after the phosphor layer has been detached from the substrate. Similarly, the thickness can also be measured directly by detaching a portion of the phosphor layer and using a stylus profile measuring system to measure the difference between the part where a portion of the phosphor layer has been detached and the part where the phosphor layer remains.

As described hereinabove, the emission efficiency of the light emitting device can be increased by setting the foregoing range for the thickness of the phosphor layer. In addition, the phosphor layer can easily be made dense by setting the foregoing range for the Dᵥ/Dₙ of the phosphor contained in the phosphor layer, thereby further raising the emission efficiency, and the viscosity when mixing with a binder resin can be reduced due to the distribution in the particle diameter, whereby the thickness of the phosphor layer can easily be made uniform, thus producing a light emitting device which combines high emission efficiency with color inconsistency suppression.

The phosphor layer of the present invention preferably has a thickness of no more than 1 mm. The thickness is more preferably no more than 500 µm, and even more preferably no more than 300 µm. The thickness of the phosphor layer does not include the substrate thickness if the phosphor layer is formed on a transparent substrate which transmits near-ultraviolet light and visible light. However, according to the present invention, since the thickness of the phosphor layer is thin, fabrication is straightforward by means of a method of applying phosphor to a transparent substrate which transmits visible light, which is preferable.

Furthermore, the difference between the maximum thickness and minimum thickness of the phosphor layer of the present invention is preferably no more than the volume median diameter D₅₀ᵥ of the phosphor, more preferably no more than 0.8 times the D₅₀ᵥ, and even more preferably no more than 0.5 times the D₅₀ᵥ. If the difference between the maximum thickness and the minimum thickness of the phosphor layer is too large, there is a difference in the emission color in places where the phosphor layer is thick and places where same is thin, and there tends to be color inconsistencies.

As described hereinabove, the phosphor layer can be easily made dense by setting the Dᵥ/Dₙ for the phosphor contained in the phosphor layer in the foregoing range, thereby raising the emission efficiency. Moreover, because the viscosity at the time of mixing with a binder resin can be reduced due to the distribution in the particle diameter, the difference between the maximum thickness and the minimum thickness of the phosphor layer can be easily set to the foregoing range, whereby a light emitting device which combines color inconsistency suppression with high emission efficiency can be produced.

Note that the difference between the maximum thickness and minimum thickness of the phosphor layer of the present invention is preferably no more than 20 µm, more preferably no more than 15 µm, even more preferably no more than 10 µm, particularly preferably no more than 8 µm, and most preferably no more than 5 µm. Note that, if the phosphor layer comprises a plurality of types of phosphor, such as red, green and blue phosphor, for example, the volume median diameter represents the median diameter of the phosphor mixture obtained by mixing each of these phosphors.

Meanwhile, in a case where the phosphor layer of the present invention is shaped such that the surface on the light emission side of the light emitting device is textured, the fluorescent light is readily scattered at the surface of the phosphor layer, and there is a small amount of fluorescent light which returns inside the phosphor layer without being emitted, and hence the efficiency of light extraction from the phosphor layer is high, which is preferable. More specifically, the surface roughness Ra on the light emission side of the light emitting device is preferably at least 1 µm. Note that the surface roughness of the present invention is the arithmetic average roughness according to B0601 of the Japanese Industrial Standards (JIS).

### <1-2. Method of fabricating phosphor layer>

As the foregoing method for fabricating the phosphor layer, the same method as the method for fabricating the light emitting material described subsequently can be used.
Further, fabrication may also be performed by a formation method using screen printing or a doctor blade, a formation method using inkjet printing, a transfer method, or an exposure application method which is used for CRT (Cathode Ray Tube) application.
In a case where formation involves screen printing, fabrication can be performed by mixing phosphor powder with binder resin to produce a paste and using a patterned screen to transfer the paste to a transparent substrate with a squeegee. Due to their ease of application in screen printing and leveling properties, binder resins which are preferably used are silicone resin, acrylic urethane resin, polyester urethane resin or the like. For the formation of a dense layer in particular, a low-viscosity resin is preferably used because when there is a large proportion of phosphor, the paste becomes highly viscous and hard to apply, and a resin with a viscosity of no more than 3000 cp, more preferably no more than 2000 cp, and particularly preferably no more than 1000 cp is used. Furthermore, a resin with a viscosity of at least 10 cp, more preferably at least 50 cp, and particularly preferably at least 100 cp is used.
In addition, when a phosphor powder and binder resin are mixed together to create a paste, an organic solvent may be added and mixed in. The viscosity can be adjusted by using the organic solvent. Further, by applying heat following transfer to the substrate to remove the organic solvent, the phosphor can be densely filled in the phosphor layer. Because volatilization is difficult at normal temperatures yet volatilization is rapid upon application of heat, preferably used organic solvents include cyclohexanone and xylene.
Furthermore, materials for the transparent substrate which can be used are not subjected to any particular restrictions as long as same are transparent to visible light, and glass and plastic and the like can be used. Among the plastics, resins preferably include epoxy resin, silicone resin, acrylic resin, polycarbonate resin, PET resin, and PEN resin, more preferably PET resin, PEN resin, and polycarbonate resin, and even more preferably PET resin.
Otherwise, formation may be performed by means of the method disclosed in Japanese Patent Application Laid-open No. 2008-135539, and more specifically, by forming a binder layer by applying a binder, whose main component is a resin such as a silicone resin, epoxy resin and so on, to a transparent substrate by means of a dispensing or spraying method or another method, and then using a compressed gas or the like to blow the phosphor powder so that same adheres to the binder layer.

### <2-1. Phosphor>

The phosphor which is used in the present invention is a phosphor which is excited by light emitted by the semiconductor light emitting element and which is capable of emitting light of a longer wavelength than the light emitted by the semiconductor light emitting element.
Further, the phosphor which is used in the present invention exhibits a high degree of wavelength range overlap between the emission wavelength range in the emission spectrum and the excitation wavelength range in the excitation spectrum. In this case, a so-called self-absorption phenomenon may occur in which the fluorescent light emitted by a certain phosphor particle is absorbed by another phosphor particle of the same type, while the other phosphor particle emits light by being excited by the absorbed light. The light emitting device of the present invention is able to improve the phosphor emission efficiency even in a case where phosphor subjected to these conditions is used.
Note that the phosphor which is used by the present invention may comprise only one type of phosphor or may comprise a phosphor mixture which comprises plural-type phosphors of two or more types. If the phosphor comprises a phosphor mixture containing plural-type phosphors of two or more types, the phosphor mixture may comprise, for example, a first phosphor capable of emitting a longer wavelength light than the light emitted by the semiconductor light emitting element, by being excited by the light emitted by the semiconductor light emitting element, and a second phosphor which is capable of emitting a longer wavelength light than the light emitted by the first phosphor by being excited by the light emitted by the semiconductor light emitting element. In addition, the first phosphor may be capable of emitting first light of a longer wavelength than the light emitted by the semiconductor light emitting element, by being excited by the light emitted by the semiconductor light emitting element and the second phosphor may be capable of emitting second light of a longer wavelength than the first light by being excited by the first light. Further, the phosphor mixture may also contain a third phosphor which is capable of emitting light of a longer wavelength than the light emitted by the semiconductor light emitting element by being excited by the light emitted by the semiconductor light emitting element and, in this case, the third phosphor may be capable of emitting a third light of a longer wavelength than the first light and/or second light by being excited by the first light and/or second light.
Further, in a case where the foregoing plural-type phosphors of two of more types are used, depending on the phosphor types, the value of D₅₀ᵥ may be the same or may be different. Normally, if a plurality of types of phosphors of different wavelengths are used as mentioned above, the value of D₅₀ᵥ is often different depending on the phosphor type. The maximum value for the difference in the D₅₀ᵥ value in a case where a plurality of phosphors with different values for D₅₀ᵥ are used is normally at least 1 µm, preferably at least 3 µm, more preferably at least 5 µm, even more preferably at least 8 µm, and particularly preferably at least 10 µm, and normally no more than 30 µm, preferably no more than 25 µm, more preferably no more than 20 µm, even more preferably no more than 17 µm, still more preferably no more than 15 µm, and particularly preferably no more than 12 µm. Thus, by using a phosphor mixture with a maximum value for the difference in the D₅₀ᵥ value in the aforementioned range, the Dᵥ/Dₙ of the phosphor mixture can be easily established in the above range.
The types of phosphors used in the present invention may be suitably selected, and the following phosphors may be cited as examples of phosphors for the red, green, blue, and yellow phosphors.

### <2-2. Red phosphors>

Examples of red phosphors which can be used include europium-activated alkaline-earth silicon nitride phosphor, expressed as (Mg, Ca, Sr, Ba)₂Si₅N₈:Eu, which is configured from fractured particles with a red fractured surface and which performs light emission in the red color range, europium-activated rare-earth oxycarcogenide phosphor, expressed as (Y, La, Gd, Lu)₂O₂S:Eu, which is configured from grown particles having a substantially spherical shape as a regular crystal-growth shape and which performs light emission in the red color range, phosphor which contains an oxysulfide and/or an oxynitride containing at least one element selected from the group consisting of Ti, Zr, Hf, Nb, Ta, W, and Mo which is a phosphor containing an oxynitride with an alpha-SiAlON in which some or all of the element Al is substituted for the element Ga, and Mn⁴⁺-activated fluoro complex phosphor such as M₂XF₆:Mn (here, M contains one or more types selected from the group consisting of Li, Na, K, Rb, Cs and NH₄ and X contains one or more types selected from the group consisting of Ge, Si, Sn, Ti, Na, Al, and Zr).

Additional phosphors which can be used include Eu-activated oxysulfide phosphors such as (La, Y)₂O₂S:Eu, Eu-activated oxide phosphors such as Y (V, P)O₄ :Eu and Y₂O₃:Eu, Eu- and Mn-activated silicate phosphors such as (Ba, Sr, Ca, Mg)₂ SiO₄:Eu, Mn, and (Ba, Mg)₂SiO₄:Eu, Mn, Eu-activated sulfide phosphors such as (Ca, Sr) S:Eu, Eu-activated aluminate phosphors such as YAlO₃:Eu, Eu-activated silicate phosphors such as LiY₉(SiO₄)₆O₂:Eu, Ca₂Y₈ (SiO₄)₆O₂:Eu, (Sr, Ba, Ca)₃SiO₅:Eu, and Sr₂BaSiO₅:Eu, Ce-activated aluminate phosphors such as (Y, Gd)₃Al₅O₁₂:Ce and (Tb, Gd)₃Al₅O₁₂:Ce, Eu-activated nitride phosphors such as (Ca, Sr, Ba)₂Si₅N₈:Eu, (Mg, Ca, Sr, Ba) SiN₂:Eu, and (Mg, Ca, Sr, Ba) AlSiN₃:Eu, Ce-activated nitride phosphors such as (Mg, Ca, Sr, Ba) AlSiN₃:Ce, Eu- and Mn-activated halophosphate phosphors such as (Sr, Ca, Ba, Mg)₁₀ (PO₄)₆C₁₂:Eu, Mn, Eu- and Mn-activated silicate phosphors such as Ba₃MgSi₂O₈:Eu, Mn, (Ba, Sr, Ca, Mg)₃(Zn, Mg) Si₂O₈:Eu, Mn, Mn-activated germanium silicate phosphors such as 3.5MgO·0.5MgF₂·GeO₂:Mn, Eu-activated nitride phosphors such as Eu-activated α-SiAlON, Eu- and Bi-activated oxide phosphors such as (Gd, Y, Lu, La)₂O₃: Eu, Bi, Eu- and Bi-activated sulfide phosphors such as (Gd, Y, Lu, La)₂O₂S:Eu, Bi, Eu- and Bi-activated vanadate phosphors such as (Gd, Y, Lu, La) VO₄:Eu, Bi, Eu- and Ce-activated sulfide phosphors such as SrY₂S₄:Eu, Ce, Ce-activated sulfide phosphors such as CaLa₂S₄:Ce, Eu- and Mn-activated phosphate phosphors such as (Ba, Sr, Ca)MgP₂O₇:Eu, Mn, and (Sr, Ca, Ba, Mg, Zn)₂P₂O₇:Eu, Mn, Eu- and Mo-activated tungstate phosphors such as (Y, Lu)₂WO₆:Eu, Mo, Eu- and Ce-activated nitride phosphors such as (Ba, Sr, Ca)ₓSi_{y}N₂:Eu, Ce (where x, y, and z are integers of 1 or more), Eu- and Mn-activated halophosphate phosphors such as (Ca, Sr, Ba, Mg)₁₀(PO₄)₆(F, Cl, Br, OH)₂:Eu, Mn, and Ce-activated silicate phosphors such as ((Y, Lu, Gd, Tb)₁₋ₓ ScₓCe_{y})₂(Ca, Mg)₁₋ᵣ(Mg, Zn)₂₊ᵣSi_{z-q}GeqO_{12+δ}. Furthermore, SrAlSi₄N₇ which appears in a WO 2008/096300 and Sr₂Al₂Si₉O₂N₁₄ :Eu which appears in US Patent Publication No. 7524437 can also be used.
Of the foregoing phosphors, Eu-activated nitride phosphors such as (Mg, Ca, Sr, Ba) AlSiN₃:Eu and CaAlSi (N, O)₃:Eu (abbreviation:CASON) are preferably used.
The phosphors given as examples of preferred phosphors have a broad excitation band of between 350 nm and 600 nm, and hence when a blue phosphor, green phosphor, and yellow phosphor are combined, blue fluorescent light will likely be emitted through excitation upon absorption of the fluorescent light of these phosphors.

### <2-3. Green phosphors>

Examples of green phosphors which can be used include europium-activated alkaline-earth silicon oxynitride phosphor, expressed as (Mg, Ca, Sr, Ba)Si₂O₂N₂:Eu, which is configured from fractured particles with a fractured surface and which performs light emission in the green color range, europium-activated alkaline-earth silicate phosphor, expressed as (Ba, Ca, Sr, Mg)₂SiO₄:Eu, which is configured from fractured particles with a fractured surface and which performs light emission in the green color range, and Eu-activated nitride phosphors such as M₃Si₆O₁₂N₂:Eu (where M represents the alkaline-earth metal) which appears in WO 2007-088966.

Further, additional phosphors which can also be used include Eu-activated aluminate phosphors such as Sr₄Al₁₄O₂₅:Eu, (Ba, Sr, Ca) Al₂O₄:Eu, Eu-activated silicate phosphors such as (Sr, Ba) Al₂Si₂O₈:Eu, (Ba, Mg)₂SiO₄:Eu, (Ba, Sr, Ca, Mg)₂SiO₄:Eu, (Ba, Sr, Ca)₂(Mg, Zn) Si₂O₇:Eu, Ce- and Tb-activated silicate phosphors such as Y₂SiO₅:Ce, Tb, Eu-activated boron phosphate phosphors such as Sr₂P₂O₇-Sr₂B₂O₅:Eu, Eu-activated halophosphate phosphors such as Sr₂Si₃O₈-2SrCl₂:Eu, Mn-activated silicate phosphors such as Zn₂SiO₄:Mn, Tb-activated aluminate phosphors such as CeMgAl₁₁O₁₉:Tb and Y₃Al₅O₁₂:Tb, Tb-activated silicate phosphors such as Ca₂Y₈(SiO₄)₆O₂:Tb, La₃Ga₅SiO₁₄:Tb, Eu-, Tb- and Sm-activated thiogallate phosphors such as (Sr, Ba, Ca) Ga₂S₄:Eu, Tb, and Sm, Ce-activated aluminate phosphors such as Y₃(Al, Ga)₅O₁₂:Ce, (Y, Ga, Tb, La, Sm, Pr, Lu)₃ (Al, Ga)₅O₁₂:Ce, Ce-activated silicate phosphors such as Ca₃Sc₂Si₃O₁₂:Ce, Ca₃ (Sc, Mg, Na, Li)₂Si₃O₁₂:Ce, Ce-activated oxide phosphors such as CaSc₂O₄:Ce, Eu-activated nitride phosphors such as SrSi₂O₂N₂:Eu, (Sr, Ba, Ca) Si₂O₂N₂:Eu and Eu-activated β-SiAlON, Eu- and Mn-activated aluminate phosphors such as BaMgAl₁₀O₁₇:Eu, Mn, Eu-activated aluminate phosphors such as SrAl₂O₄:Eu, Tb-activated oxysulfide phosphors such as (La, Gd, Y)₂O₂S:Tb, Ce- and Tb-activated phosphate phosphors such as LaPO₄:Ce, Tb, sulfide phosphors such as ZnS:Cu, Al, ZnS:Cu, Au, Al, Ce- and Tb-activated boronate phosphors such as (Y, Ga, Lu, Sc, La) BO₃:Ce, Tb, Na₂Gd₂B₂O₇:Ce, Tb, (Ba, Sr)₂ (Ca, Mg, Zn)B₂O₆:K, Ce, Tb, Eu- and Mn-activated halosilicate phosphors such as Ca₈Mg (SiO₄)₄Cl₂:Eu, Mn, Eu-activated thioaluminate phosphors or thiogallate phosphors such as (Sr, Ca, Ba) (Al, Ga, In)₂S₄:Eu, and Eu- and Mn-activated halosilicate phosphors such as (Ca, Sr)₈ (Mg, Zn) (SiO₄)₄Cl₂:Eu, Mn. Further, Sr₅Al₅Si₂₁O₂N₃₅:Eu which appears in WO 2009/072043 and Sr₃Si₁₃Al₃N₂₁O₂:Eu which appears in WO 2007/105631 can also be used. Of the foregoing phosphors, (Ba, Ca, Sr, Mg)₂SiO₄:Eu, BaMgAl₁₀O₁₇:Eu, Mn; Eu-activated β-SiAlON, and M₃Si₆O₁₂N₂:Eu (where M represents the alkaline-earth metal element) and the like can preferably be used.
Among the phosphors given as examples of preferred phosphors (Ba, Ca, Sr, Mg)₂ SiO₄: Eu, Eu-activated β sialon, and M₃Si₆O₁₂N₂₁:Eu (where M represents an alkaline-earth metal element) have a broad excitation range between 350 nm and 500 nm and BaMgAl₁₀O₁₇: Eu, and Mn between 350 nm and 440 nm, and hence in combination with a blue phosphor, green light will likely be emitted through excitation upon absorption of the light emitted by the blue phosphor.

### <2-4. Blue phosphors>

Examples of blue phosphors which can be used include europium-activated barium magnesium aluminate phosphor, expressed as BaMgAl₁₀O₁₇:Eu, which is configured from grown particles having a substantially hexagonal shape as a regular crystal-growth shape and which performs light emission in the blue color range, europium-activated calcium halo phosphate phosphor, expressed as (Ca, Sr, Ba)₅ (PO₄)₃Cl:Eu, which is configured from grown particles having a substantially spherical shape as a regular crystal-growth shape and which performs light emission in the blue color range, europium-activated alkaline-earth chloroborate phosphor, expressed as (Ca, Sr, Ba)₂ B₅O₉Cl:Eu, which is configured from grown particles having a substantially cubic shape as a regular crystal-growth shape and which performs light emission in the blue color range, and europium-activated alkaline-earth aluminate phosphor, expressedas (Sr, Ca, Ba)Al₂O₄:Eu or (Sr, Ca, Ba)₄Al₁₄O₂₅:Eu, which is configured from fractured particles having a fractured surface and which performs light emission in the blue color range or the like.

Further, additional phosphors which can be used as blue colors include Sn-activated phosphate phosphors such as Sr₂P₂O₇:Sn; Eu-activated aluminate phosphors such as Sr₄Al₁₄O₂₅:Eu, BaMgAl₁₀O₁₇:Eu, and BaAl₈O₁₃:Eu; Ce-activated thiogallate phosphors such as SrGa₂S₄:Ce and CaGa₂S₄:Ce; Eu-, Tb-, and Sm-activated aluminate phosphors such as (Ba, Sr, Ca) MgAl₁₀O₁₇:Eu and BaMgAl₁₀O₁₇:Eu, Tb, Sm; Eu- and Mn-activated aluminate phosphors such as (Ba, Sr, Ca) MgAl₁₀O₁₇:Eu, Mn; Eu-, Tb-, and Sm-activated halophosphate phosphors such as (Sr, Ca, Ba, Mg)₁₀ (PO₄)₆Cl₂:Eu, (Ba, Sr, Ca)₅(PO₄)₃ (Cl, F, Br, OH):Eu, Mn, Sb; Eu-activated silicate phosphors such as BaAl₂Si₂O₈:Eu, (Sr, Ba)₃ MgSi₂O₈:Eu; Eu-activated phosphate phosphors such as Sr₂P₂O₇:Eu, sulfide phosphors such as ZnS:Ag and ZnS:Ag, Al, Ce-activated silicate phosphors such as Y₂SiO₅:Ce; tungstate phosphors such as CaWO₄; Eu- and Mn-activated boron phosphate phosphors such as (Ba, Sr, Ca) BPO₅:Eu, Mn, (Sr, Ca)₁₀(PO₄)₆·nB₂O₃:Eu, 2SrO·0.84P₂O₅·0.16B₂O₃:Eu, and Eu-activated halophosphate phosphors such as Sr₂Si₃O₈·2SrCl₂:Eu.
Of the foregoing phosphors, (Sr, Ca, Ba)₁₀(PO₄)₆Cl₂:Eu²⁺, BaMgAl₁₀O₁₇:Eu can preferably be used. Further, of the phosphors denoted by (Sr, Ca, Ba)₁₀(PO₄)₆Cl₂:Eu²⁺, a phosphor denoted by SrₐBa_{b}Euₓ (PO₄)_{c}Cl_{d} can preferably be used (where c, d and x are numbers satisfying 2.7 ≤ c ≤ 3.3, 0.9 ≤ d ≤ 1.1, and 0.3 ≤ x ≤ 1.2, with x preferably being 0.3 ≤ x ≤ 1.0. Further, a and b satisfy the conditions a+b = 5-x and 0.05 ≤ b/(a+b) ≤ 0.6 and b/(a+b) is preferably 0.1 ≤ b/(a+b) ≤ 0.6).

### <2-5. Yellow phosphors>

Yellow phosphors include various oxide, nitride, oxynitride, sulfide, and oxysulfide phosphors. In particular, garnet phosphors with a garnet structure denoted by RE₃M₅O₁₂:Ce (here, RE represents at least one element selected from the group consisting of Y, Tb, Gd, Lu, and Sm, and M represents at least one element selected from the group consisting of Al, Ga, and Sc), and Ma₃Mb₂Mc₃O₁₂:Ce (here Ma represents a di-valent metal element, Mb represents a tri-valent metal element, and Mc represents a 4-valent metal element), orthosilicate phosphors, denoted by AE₂MdO₄:Eu (here, AE represents at least one element selected from the group consisting of Ba, Sr, Ca, Mg, and Zn, and Md represents Si, and/or Ge), oxynitride phosphors obtained by substituting nitrogen for part of the oxygen of the constituent element of the foregoing phosphors, and phosphors obtained by Ce-activating a nitride phosphor having a CaAlSiN₃ structure such as AEAlSiN₃:Ce (here AE represents at least one element selected from the group consisting of Ba, Sr, Ca, Mg, and Zn).

Furthermore, additionally, examples of yellow phosphors which can be used include sulfide phosphors such as CaGa₂S₄:Eu, (Ca, Sr) Ga₂S₄:Eu, (Ca, Sr) (Ga, Al)₂S₄:Eu, Eu- activated phosphors such as oxynitride phosphors which have an SiAlON structure such as Caₓ (Si, Al)₁₂ (O, N)₁₆:Eu, Eu-activated or Eu- and Mn-activated boron halide phosphors such as (M_{1-A-B}Eu_{A}Mn_{B})₂ (BO₃)_{1-P} (PO₄)ₚX (where M represents at least one element selected from the group consisting of Ca, Sr, and Ba, and X represents at least one element selected from the group consisting of F, Cl, and Br. A, B, and P each represent numbers which satisfy 0.001 ≤ A ≤ 0.3, 0 ≤ B ≤ 0.3, 0 ≤ P ≤ 0.2), and may contain alkaline earth metals, and, for example, Ce-activated oxynitride phosphors having a structure of La₃Si₃N₁₁ may be used. Note that the foregoing Ce-activated nitride phosphors may also be partially substituted with Ca and O.

### <3. Light emitting members>

The phosphor layer of the present invention may comprise one or more types of light emitting members comprising phosphor. The phosphor layer preferably comprises a first light emitting member and a second light emitting member, wherein the first light emitting member comprises a first phosphor which is capable of emitting a longer wavelength light than the light emitted by the semiconductor light emitting element by being excited by the light emitted by the semiconductor light emitting element, and the second light emitting member comprises a second phosphor which is capable of emitting a longer wavelength light than the light emitted by the first phosphor by being excited by the light emitted by the semiconductor light emitting element, and the first and second light emitting members in the phosphor layer are formed as separate members in a direction perpendicular to the thickness direction of the phosphor layer, thereby enabling cascade excitation to be prevented and the emission efficiency of the phosphor layer to be increased. The phosphor layer may further comprise a third light emitting member containing a third phosphor which is capable of emitting light containing a different wavelength component from those of the first and second phosphors.

The first and second phosphors can be suitably selected according to the wavelength of the light emitted by the semiconductor light emitting element. For example, in a case where the wavelength of the excitation light from the semiconductor light emitting element is in the near-ultraviolet or violet range, that is, a wavelength of about 350 nm to 430 nm, blue, green, and red phosphors can be selected according to the targeted emission spectrum. Further, phosphors of intermediate colors such as blue-green, yellow, and orange may also be used depending on requirements. More specifically, examples of possible aspects are an aspect in which the first phosphor is blue and the second phosphor is yellow, an aspect in which the first phosphor is green, the second phosphor is red, and the third phosphor is blue, an aspect in which the first phosphor is blue, the second phosphor is green, and the third phosphor is red, and an aspect in which the first phosphor is blue, the second phosphor is red, and the third phosphor is green.
Further, in a case where the wavelength of the excitation light of the semiconductor light emitting element is in the blue range, that is, a wavelength of about 430 nm to 480 nm, normally the blue light uses the emission light of the semiconductor light emitting element as is and hence an aspect in which the first phosphor is green and the second phosphor is red can be given by way of example.

In the phosphor layer of the present invention, the first light emitting members and second light emitting members are preferably formed as separate members in a direction perpendicular to the thickness direction of the phosphor layer. More preferably, the first light emitting member are formed without adjoining one another and the second light emitting members are formed without adjoining one another.
The first and second light emitting members are formed such that a first light emitting member comprising the first phosphor and a second light emitting member comprising the second phosphor are disposed adjacent to one another on a transparent substrate which transmits near-ultraviolet light and visible light, for example. "Separate members" indicates a state where if the first and second light emitting members are disposed on the transparent substrate, both members are not formed after mixing, rather, independent layers of each are formed. That is, the first phosphor and second phosphor which are contained in the first light emitting member and the second light emitting member do not exist together, but instead exist in separate spatial areas.

An aspect of the light emitting members in the phosphor layer of the present invention is illustrated below in a relationship with the semiconductor light emitting element.
(a) In a case where a semiconductor light emitting element which emits excitation light in a blue range is used, each of the following aspects (a-1) to (a-4) may be cited.
   (a-1) A phosphor layer comprising a light emitting member comprising a mixture in which a red phosphor and a green phosphor are mixed together.
   (a-2) A phosphor layer comprising a light emitting member comprising a yellow phosphor.
   (a-3) A phosphor layer in which a first light emitting member comprising a green phosphor and a second light emitting member comprising a red phosphor are painted as separate members.
   (a-4) A phosphor layer in which a first light emitting member comprising a green phosphor, a second light emitting member comprising a red phosphor, and a third light emitting member comprising a yellow phosphor are painted as separate members.
(b) In cases where semiconductor light emitting elements which emit light in the near-ultraviolet range or excitation light in the violet range are used, the following aspects (b-1) to (b-9) may be cited.
   (b-1) A phosphor layer which comprises a light emitting member which comprises a mixture obtained by mixing a red phosphor, a green phosphor, and a blue phosphor.
   (b-2) A phosphor layer comprising a light emitting member which comprises a mixture obtained by mixing a blue phosphor and a yellow phosphor.
   (b-3) A phosphor layer in which a first light emitting member comprising a green phosphor, a second light emitting member comprising a red phosphor, and a third light emitting member comprising a blue phosphor are painted as separate members.
   (b-4) A phosphor layer in which a first light emitting member comprising a blue phosphor, a second light emitting member comprising a green phosphor, and a third light emitting member comprising a red phosphor are painted as separate members.
   (b-5) A phosphor layer in which a first light emitting member comprising a blue phosphor, a second light emitting member comprising a red phosphor, and a third light emitting member comprising a green phosphor are painted as separate members.
   (b-6) A phosphor layer in which a first light emitting member comprising a blue phosphor, and a second light emitting member comprising a yellow phosphor are painted as separate members.
   (b-7) A phosphor layer in which a first light emitting member comprising a green phosphor, a second light emitting member comprising a red phosphor, a third light emitting member comprising a blue phosphor, and a fourth light emitting member comprising a yellow phosphor are painted as separate members.
   (b-8) A phosphor layer in which a first light emitting member comprising a blue phosphor, a second light emitting member comprising a green phosphor, a third light emitting member comprising a red phosphor, and a fourth light emitting member comprising a yellow phosphor are painted as separate members.
   (b-9) A phosphor layer in which a first light emitting member comprising a blue phosphor, a second light emitting member comprising a red phosphor, a third light emitting member comprising a green phosphor, and a fourth light emitting member comprising a yellow phosphor are painted as separate members.
Note that when the foregoing combinations of phosphors with the semiconductor light emitting element are selected, the light emitted by the light emitting device can be white.

The method of fabricating the foregoing light emitting member may involve fabrication by mixing a phosphor powder with a binder resin and organic solvent to form a paste, applying the paste to a transparent substrate, and performing drying and firing to remove the organic solvent, or may involve forming a paste from phosphor and an organic solvent without using a binder and fabricating a dried and fired body by means of press molding. In a case where a binder is used, the binder can be used without restrictions on the type, and an epoxy resin, silicone resin, acrylic resin, and polycarbonate resin and the like are preferably used.

In a case where a transparent substrate which transmits visible light is used, the material thereof is not subjected to any particular restrictions as long as it is transparent to visible light, and glass or plastic (for example, epoxy resin, silicone resin, acrylic resin, polycarbonate resin or the like) can be used. Glass is preferable from a durability standpoint if excitation is performed using wavelengths in the near-ultraviolet range.

### <4. Surface area of overlap of light emitting members>

In a case where the phosphor layer of the present invention comprises light emitting members of a plurality of types, it is preferable to form separate light emitting members in a direction perpendicular to the thickness direction such that overlapping parts are reduced in the thickness direction of the phosphor layer at the interface between the light emitting members because cascade excitation can be prevented and emission efficiency can be improved.
More specifically, the phosphor layer is preferably configured such that the proportion of the surface area of the part having phosphors of a plurality of types in the thickness direction of the phosphor layer relative to the light emission surface area of the light emitting device is 0% or more and 20% or less in order to improve the emission efficiency.
Here, "light emission surface area of the light emitting device" indicates the surface area of the part passing light emitted by the light emitting device to the outside, of the surface area of the light emitting device. Furthermore, "surface area of the part having phosphors of a plurality of types in the thickness direction of the phosphor layer" means the projection surface area when the part having phosphors of a plurality of types in the thickness direction of the phosphor layer is projected onto the surface on the emission direction side from the thickness direction of the phosphor layer.

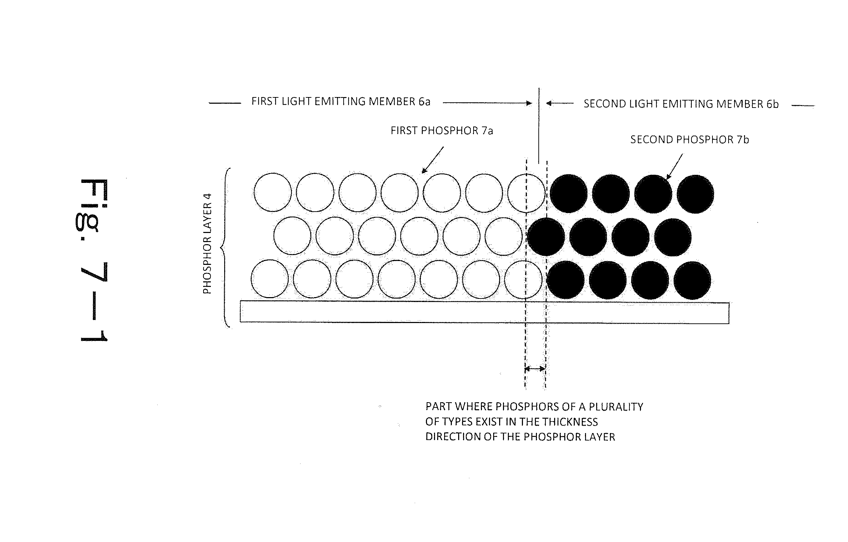

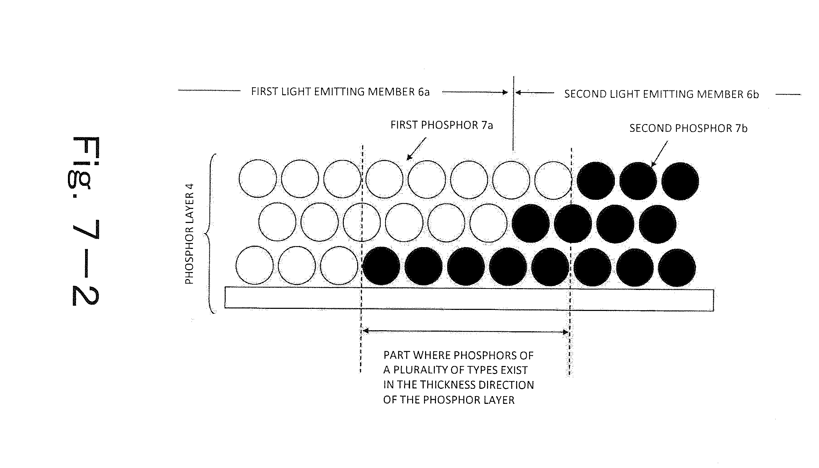

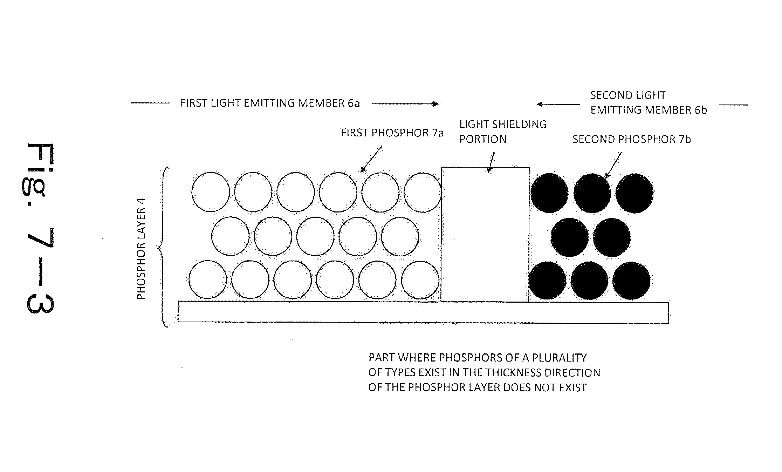

Figs. 7-1 to 7-3 illustrate the contact faces of adjoining light emitting members. Parts where there is overlap between phosphors of a plurality of types exist in the thickness direction of the phosphor layer at the contact face. In overlapping parts, cascade excitation is generated extremely easily. Hence, shifting from the state in Fig. 7-2 to the state in Fig. 7-1 is preferable because cascade excitation can thus be prevented. More preferably, cascade excitation can be further prevented with a configuration like that in Fig. 7-3 by means of a method in which a light-shielding portion is provided between the light emitting members. The proportion of the surface area of the parts where a plurality of the phosphors exist is preferably no more than 10%, more preferably no more than 5%, and most preferably 0%.

The surface area of the overlapping parts where phosphors of a plurality of types exist in the phosphor layer according to the present invention can be measured by cutting the phosphor layer in the thickness direction and observing the cross section using a SEM or other electron microscope. The phosphor layer of the present invention is fabricated with a plurality of light emitting member disposed and hence a plurality of contact faces formed by adjoining light emitting members exist. Hence, this is expressed as the sum of the surface area of the overlapping parts due to phosphors of a plurality of types overlapping and the surface area of overlapping parts, in the phosphor layer, which exist in the light emission surface area of the light emitting device.

### <5. Phosphor pattern>

In a case where the phosphor layer of the present invention comprises light emitting members of a plurality of types, the first and second light emitting members are preferably disposed as separate members in a direction perpendicular to the thickness direction of the phosphor layer, but a variety of placement aspects may be considered.
First, examples of shapes for the first and second light emitting members include stripes, triangles, squares, hexagons, circles and the like.

Furthermore, the phosphor layer of the present invention preferably comprises first and second light emitting members disposed as patterns and more preferably comprises first and second light emitting members disposed as stripes. Here, "disposed as patterns" refers to a configuration which comprises at least one or more first light emitting members and one or more second light emitting members, and in which configuration units, comprising first and second light emitting members which are alternately arranged such that identical members do not adjoin one another, are disposed in a regular, repetitive fashion. Further, here, "disposed in stripes" refers to a configuration in which the first and second light emitting members have the same size and the same shape and the first and second light emitting members are disposed alternately without identical light emitting members adjoining one another. As specific examples of stripe shapes, one possible configuration is one in which the first and second light emitting members are of the same size and have the same square shape and are disposed alternately such that identical members do not adjoin one another. Specific layout patterns for light emitting members will be illustrated hereinbelow.

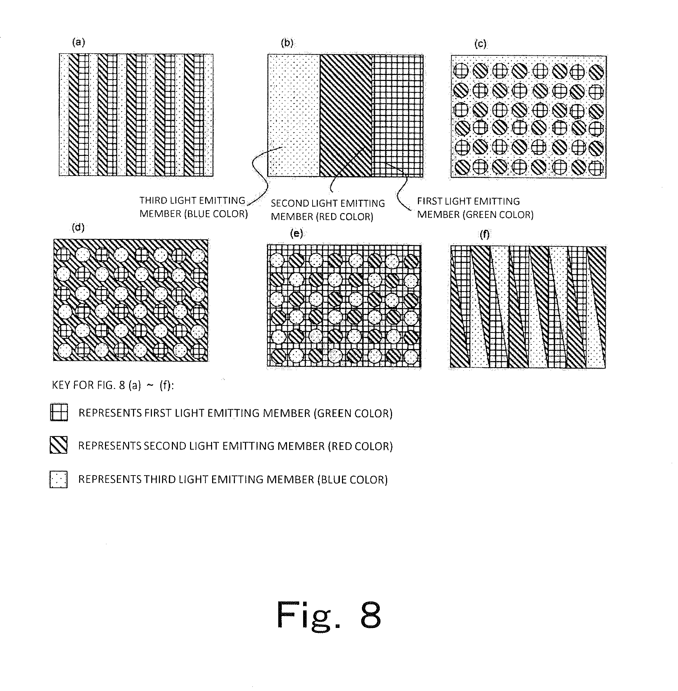

Fig. 8 illustrates phosphor layer patterns which, in a case where a semiconductor light emitting element emits light of wavelengths in the near-ultraviolet or violet range, comprises, as the phosphor layer, a first light emitting member comprising a green phosphor, a second light emitting member comprising a red phosphor, and, in addition, a third light emitting member comprising a blue phosphor.
Figs. 8A and 8B show phosphor layer patterns in which light emitting members of an oblong shape are disposed in stripes, Figs. 8C, 8D, and 8E represent phosphor layer patterns in which light emitting members of a circular shape are disposed, and Fig. 8F shows a phosphor layer pattern in which light emitting members of a triangular shape are disposed.

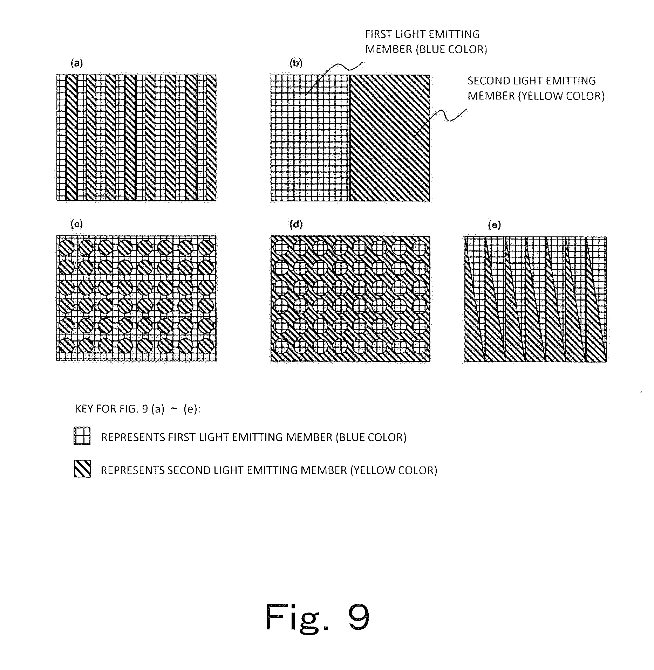

Meanwhile, if the semiconductor light emitting element emits light in the near-ultraviolet or violet range, the phosphor layer pattern may comprise, as the phosphor layer, a first light emitting member which comprises a blue phosphor and a second light emitting member which comprises a yellow phosphor. Such phosphor layer patterns are shown in Figs. 9A to 9E.

Furthermore, in a case where the semiconductor light emitting element emits light of wavelengths in the blue color range, the phosphor layer pattern may comprise, as the phosphor layer, a first light emitting member which comprises a green phosphor and a second light emitting member which comprises a red phosphor. The pattern in this case is also illustrated by the pattern shown in Fig. 9 in which the first light emitting member is green and the second light emitting member is red.

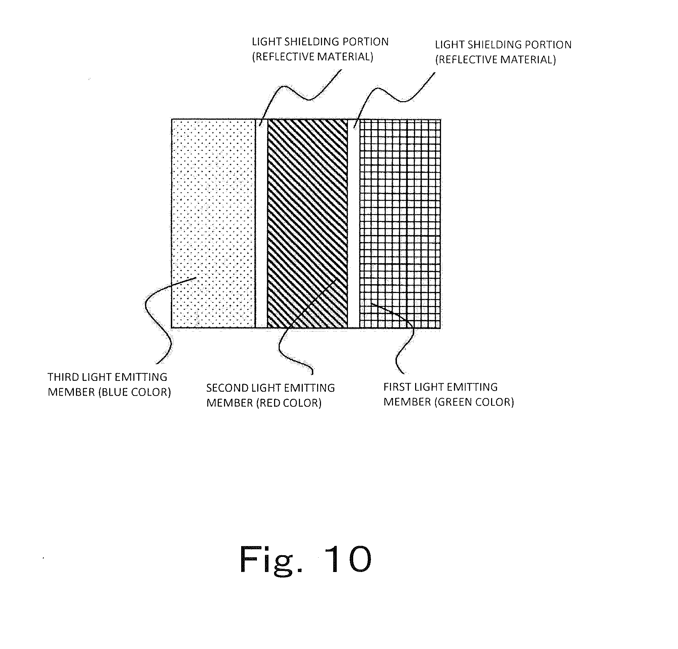

Additionally, in a case where the semiconductor light emitting element emits light of a wavelength in the blue color range and where a transparent substrate which transmits visible light is used, a pattern which may be used in a pattern in which the third light emitting member comprising a blue phosphor is not installed and which transmits the blue light emitted from the semiconductor light emitting element as is.
In addition, the patterns in which a light-shielding portion is provided at the interface between each of the light emitting members in Figs. 8 and 9 can also be provided. As a specific aspect, for example, a pattern in which a light-shielding portion is provided at the interface between light emitting members in Fig. 8B is shown in Fig. 10. The light-shielding portion is preferably disposed to prevent the light emitted by the first light emitting member from entering the second light emitting member. Furthermore, the light-shielding portion is preferably a black matrix or a reflective material and more preferably a reflective material.
Further, as specific examples of the light-shielding portion include a light-shielding portion obtained by dispersing highly reflective particles in a binder resin. Highly reflective particles are preferably alumina particles, titanium particles, silica particles, zirconium particles, more preferably alumina particles, titanium particles, and silica particles, and even more preferably alumina particles.

### <6. Semiconductor light emitting element>

The semiconductor light emitting element of the present invention emits the excitation light of the phosphor contained in the first light-emitting member and second light-emitting member. The wavelength of the excitation light is 350 nm or more and 520 nm or less, preferably at least 370 nm, and more preferably at least 380 nm. Further, this wavelength is preferably not more than 500 nm and more preferably not more than 480 nm.
In particular, in a case where the light emitted by the semiconductor light emitting element is light in the near-ultraviolet range or ultraviolet range, a light emitting device with superior color rendering properties can preferably be provided.

Specific examples of the semiconductor light emitting element which may be given include semiconductor light emitting elements which use a InGaAlN, GaAlN or InGaAlN semiconductor or similar for which crystal growth is performed using the MOCVD method or the like on a silicon carbide, sapphire, or gallium nitride substrate. In the light emitting device of the present invention, a plurality of semiconductor light emitting elements are preferably used aligned in a planar shape. The present invention is preferably used in a light emitting device which comprises such a large emission surface area.

### <7. Further members which may be included in the light emitting device of the present invention>

The light emitting device of the present invention can comprise a package for holding a semiconductor light emitting element and which has an optional shape and material. Specific shapes which can be used are plate shape, cup shape, or any suitable shape depending on the application. Among these shapes, a cup-shaped package is preferable since this shape is able to retain directivity in the light emission direction and is able to effectively use the light emitted by the light emitting device. In a case where a cup-shaped package is adopted, the surface area of the opening for emitting light is preferably 120% or more and 600% or less of the base surface area. Further, possible package materials which can be used include suitable materials depending on the application such as inorganic materials such as metals, glass alloys and carbons, and organic materials such as synthetic resins.

If a package is used in the present invention, a material with a high reflectance across the whole near-ultraviolet and visible light ranges is preferable. Highly reflective packages of this type include packages which are formed of silicone resin and which comprise light scattering particles. Possible examples of light scattering particles include titanium and alumina.

Further, the light emitting device of the present invention preferably comprises, on the light emission side of the light emitting device of the phosphor layer, a bandpass filter which reflects at least a portion of the light emitted by the semiconductor light emitting element and transmits at least a portion of the light emitted by the phosphor. By adopting this aspect, the excitation light which passes through the phosphor layer without being absorbed by the phosphor is able to return once more to the phosphor layer to excite the phosphor, whereby the output of the light emitting device can be improved.
In addition, the light emitting device of the present invention preferably provides, on the semiconductor light emitting element side of the phosphor layer, a bandpass filter which transmits at least a portion of the excitation light emitted by the semiconductor light emitting element and at least a portion of the light emitted by the phosphor. By adopting this aspect, it is possible to prevent the fluorescent light emitted by the phosphor from re-entering the package, whereby the output of the light emitting device can be improved.
Commercial bandpass filters can suitably be used in the present invention, where the type of bandpass filter is suitably selected according to the type of semiconductor light emitting element.

Further, metal wiring for supplying power from the outside to the semiconductor light emitting element and a cap to protect the light emission direction side of the phosphor layer, and so on, can be suitably disposed.

### <8. Light emitting device of the present invention>

As will be described subsequently, the light emitting device of the present invention is preferably configured comprising two or more areas with different emission spectra in the phosphor layer, for example an area A and an area B, and such that the phosphor layer or the semiconductor light emitting element move in a direction perpendicular to the thickness direction of the phosphor layer.

In a case where such a configuration is adopted, the area A and area B which the phosphor layer comprises are areas of different emission spectra for the light which is emitted from each of these areas, and hence, by changing the proportion of area A and area B which occupy the light emission area of the light emitting device, it is possible to continuously adjust the emission spectrum of the light emitted from the light emitting device, whereby a light emitting device which emits light of the desired emission spectrum can be produced. In particular, when the areas A and B are areas in which the color temperature of the emitted light is different, the color temperature of the light emitted from the light emitting device can be adjusted continuously from 2800 K to 6500 K, for example, by changing the proportion of the areas A and B which occupy the light emission area of the light emitting device.

In order to provide an area A and an area B of different emission spectra, consideration may be given to adjusting the emission spectra by affording the first and second light emitting members the same surface area, that is, the same pattern, in the area A and area B, for example, and changing the phosphor type and content ratio contained in the first light emitting member and/or second light emitting member. In a case where the semiconductor light emitting element emits excitation light in the blue color range, the emission spectra can be changed by using the same first light emitting member (green color) in both area A and area B, for example, and by making the second light emitting member used in area B comprise a phosphor of a different type, which is a phosphor of the same color (red) as the phosphor which the second light emitting member used in area A comprises. The emission spectra can also be changed by changing the phosphor content in the second light emitting member in areas A and B.

However, the emission spectra can also be changed by using identical first and second light emitting members in area A and area B and by changing, in area A and area B, the proportion of the surface area of the second light emitting member which occupies the whole surface area of each area. For example, the surface area of the second light emitting member which is used in area B can be made larger than the surface area of the second light emitting member which is used in area A.

Area A and area B which the phosphor layer of the present invention comprises are suitably disposed with different emission spectra. More particularly, area A and area B are suitably disposed such that the color temperatures of the emission light are different. Possible aspects of the area A and area B in the phosphor layer include combinations of:
● an aspect in which red and green phosphors are painted for use with the semiconductor light emitting element which emits light of a wavelength in the blue color range;
● an aspect in which red, green, and blue phosphors are painted for use with the semiconductor light emitting element which emits light of a wavelength in the near-ultraviolet or ultraviolet range; and
● an aspect in which blue and yellow phosphors are painted for use with the semiconductor light emitting element which emits light of a wavelength in the near-ultraviolet or ultraviolet range.

The phosphor layer of the present invention which comprises such areas A and B is designed larger than the emission surface area of the light emitting device and hence, by moving the phosphor layer, it is possible to adjust the proportions of two types of light of different emission spectra in the light which is emitted from area A and the light emitted from area B. The emission spectra can also be adjusted, even without moving the phosphor layer, by moving the semiconductor light emitting element (package if a package is provided).

As means for moving the phosphor layer and/or semiconductor light emitting element, manual driving or driving by means of an actuator or motor may be considered. The movement direction may be linear movement or rotational movement.

The present invention will be described hereinbelow with reference to embodiments of the light emitting device of the present invention. The present invention is not limited to the following embodiments, rather, optional modifications can be carried out without departing from the spirit and scope of the present invention.

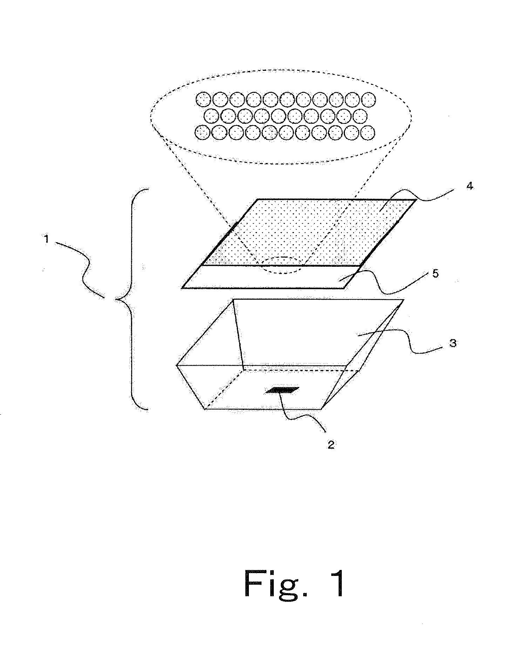

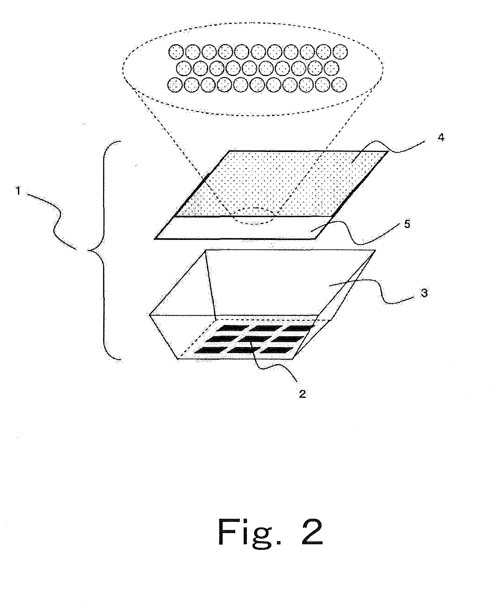

Fig. 1 and 2 show a schematic diagram of an overall view of a light emitting device 1 of the present invention. The light emitting device 1 is a light emitting device in which a semiconductor light emitting element 2 is disposed on a flat face, and the semiconductor light emitting element 2 is disposed on the bottom face of a hollow portion of a package 3. Further, a phosphor layer 4 is disposed in an opening in the package 3.

For the semiconductor light emitting element 2, a near-ultraviolet semiconductor light emitting element which emits light of a wavelength in the near-ultraviolet range, a violet semiconductor light emitting element which emits light of a violet semiconductor light emitting element which emits light of a wavelength in the violet color range, or a red semiconductor light emitting element which emits light of a wavelength in the blue color range can be used, however in this embodiment a violet semiconductor light emitting element will be described by way of example. Furthermore, as per this embodiment, a single semiconductor light emitting element may be installed (Fig. 1) or a plurality of semiconductor light emitting elements may be disposed in a planar shape (Fig. 2). Further, the light emitting device can also be configured by installing a single large-output semiconductor light emitting element. In particular, configuring a light emitting device either by disposing a plurality of semiconductor light emitting elements in a planar shape or by installing a single large-output semiconductor light emitting element permits straight-forward surface lighting and is therefore preferable.

The package 3 holds the semiconductor light emitting elements and phosphor layer and, in this embodiment, is cup-shaped with an opening and a hollow portion, and the semiconductor light emitting element 2 is disposed on the bottom face of the hollow portion. If the package 3 is cup-shaped, the directivity of the light emitted from the light emitting device can be retained and the emitted light can be better used. Note that the specifications of the hollow portion of the package 3 are set as specifications enabling the light emitting device 1 to emit light in a predetermined direction. Further, the bottom portion of the hollow portion of the package 3 comprises electrodes (not shown) for supplying power to the semiconductor light emitting element from the outside of the light emitting device 1. A highly reflective package is preferably used for the package 3, thereby enabling the light striking the wall surface (tapered portion) of the package 3 to be emitted in a predetermined direction and making it possible to prevent a loss of light.

The phosphor layer 4 is disposed at the opening of the package 3. The aperture area of hollow portion of the package 3 is covered by the phosphor layer 4 and the light from the semiconductor light emitting element 2 does not pass through the phosphor layer 4 and is not emitted from the light emitting device 1.

The phosphor layer 4 is formed on a transparent substrate 5 which transmits near-ultraviolet light and visible light. When the transparent substrate 5 is used, screen printing is possible and the formation of the phosphor layer 4 is straightforward. The phosphor layer 4 which is formed on the transparent substrate has a thickness of no more than 1 mm.

In the embodiment of the present invention shown in Fig. 1 or Fig. 2, the semiconductor light emitting element 2 and the phosphor layer 4 are a distance apart, this distance being preferably at least 0.1 mm, more preferably at least 0.3 mm, even more preferably at least 0.5 mm, and particularly preferably at least 1 mm, and preferably no more than 500 mm, more preferably no more than 300 mm, even more preferably no more than 100 mm, and particularly preferably no more than 10 mm. With such embodiments, it is possible to prevent weakening of the excitation light per unit surface area of the phosphor as well as phosphor light deterioration, and a rise in temperature of the phosphor layer can be prevented even when the temperature of the semiconductor light emitting element rises. In addition, with such embodiments, even when the semiconductor light emitting elements and electrodes are connected using a bonding wire, it is possible to suppress any transfer of the heat from the phosphor layer to the vicinity of the bonding wire, and even when cracks are generated in the phosphor layer, it is possible to suppress the transmission of the resulting tensile force to the bonding wire and, as a result, breakage of the bonding wire can be prevented.

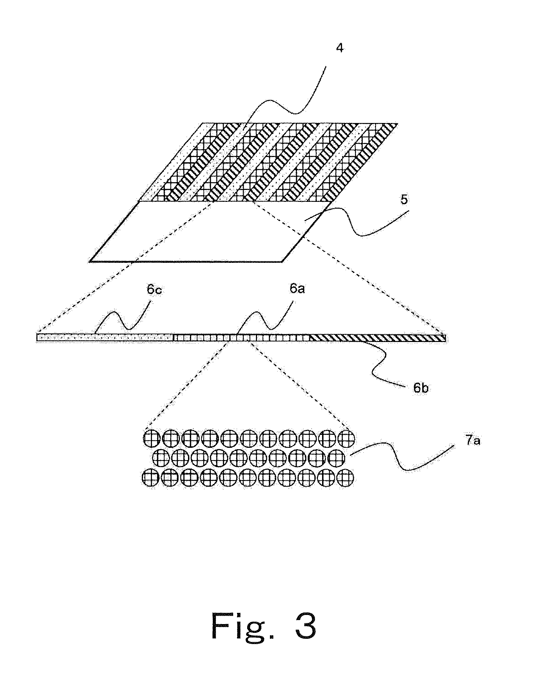

The embodiments in Figs. 1 and 2 have been described thus far but further embodiments can also be adopted. More specifically, Fig. 3 shows an embodiment in which a phosphor layer 4 comprises a first light emitting member 6a and a third light emitting member 6c.
In this embodiment, the first light emitting member 6a is a light emitting member which comprises a green phosphor 7a and which, upon excitation with the light of a violet semiconductor light emitting element 2, emits light in the green color range of a longer wavelength than the violet range light.
In this embodiment, the second light emitting element 6b is a light emitting member which comprises a red phosphor and which, upon excitation with the light of the violet semiconductor light emitting element 2, emits light in the red color range which is of a longer wavelength than the light in the green color range emitted by the green phosphor contained in the first light emitting member.
In this embodiment, the third light emitting member 6c is a light emitting member which comprises a blue phosphor and is provided in order to generate white light.

The light emitting members are suitably selected according to the type of semiconductor light emitting element used and, if a blue semiconductor light emitting element is used, the foregoing third semiconductor light emitting element is not required and light from the blue semiconductor light emitting element can be used as is as blue light for generating white light. Further, the light emitting members are each provided such that the surface area of the parts in which phosphors of a plurality of types exist in the thickness direction of the phosphor layer is between 0% and 20% of the surface area of the light emission surface area, in the light emitting device, of the phosphor layer, that is, of the surface area of the opening in the package 3. Since a plurality of light emitting members exist in the light emission surface area, the surface area of the parts where the phosphors of a plurality of types exist is calculated from the total sum of the surface area of the plurality of parts.

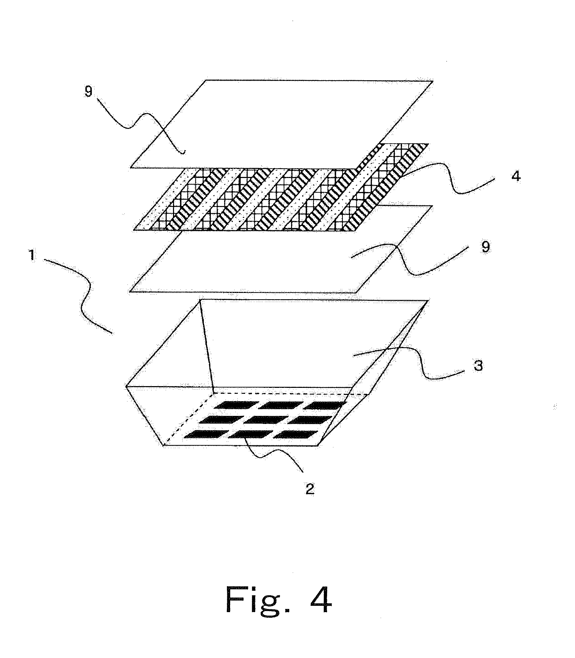

Furthermore, as per Fig. 4, a bandpass filter 9 can be provided on the light emission side of the light emitting device of the phosphor layer 4 and/or on the semiconductor light emitting element side thereof. Here, "the light emission side of the light emitting device of the phosphor layer 4" means, in a face in a direction perpendicular to the thickness direction of the phosphor layer 4, on the side of the face in the direction in which light is emitted outside the light emitting device, that is, to describe this using Fig. 4, above the phosphor layer 4. Furthermore, "on the side of the semiconductor light emitting element of the phosphor layer 4", in a face in a direction perpendicular to the thickness direction of the phosphor layer 4, on the side of the face in the direction in which light is emitted inside the light emitting device, that is, to describe this using Fig. 4, below the phosphor layer 4.
The bandpass filter 9 has material properties which transmit only light of predetermined wavelengths and, by providing, between the package 3 and the phosphor layer 4, a bandpass filter which transmits at least a portion of the light emitted by the semiconductor light emitting element and reflects at least a portion of the light emitted by the phosphor, it is possible to prevent the fluorescent light emitted by the phosphor from re-entering the package and to increase the emission efficiency of the light emitting device. Meanwhile, by providing, on the light emission side of the light emitting device of the phosphor layer 4, a bandpass filter which reflects at least a portion of the light emitted by the semiconductor light emitting element and transmits at least a portion of the light emitted by the phosphor, the light emitted by the semiconductor light emitting element which passes through without being absorbed by the phosphor is able to re-enter the phosphor layer so as to excite the phosphor, whereby the emission efficiency of the light emitting device can be increased. The bandpass filter is suitably selected according to the semiconductor light emitting element 2. Furthermore, as per Fig. 4, because a plurality of semiconductor light emitting elements are disposed in a planar shape, the proportion of the light entering in the thickness direction of the bandpass filter in the light emitted by the semiconductor light emitting element can be increased and the bandpass filter can be efficiently used.

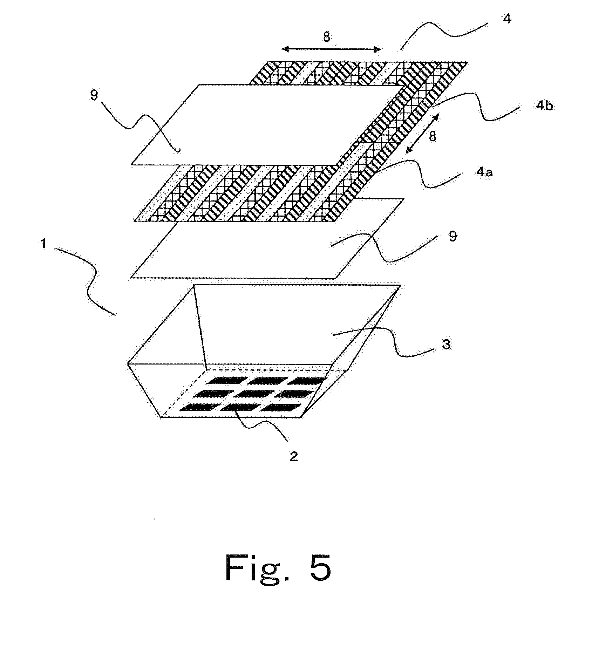

In addition, as per Fig. 5, the phosphor layer 4 comprises two areas of different emission spectra such as, for example, an A area 4a and a B area 4b with different color temperatures, and the size of the phosphor layer 4 is designed to be larger than the size of the opening in the package 3. Further, by horizontally sliding the phosphor layer 4 with a larger surface area than the opening in the package 3 while covering the opening in the package 3 (arrow 8 in the drawing is an example of the horizontal sliding direction of the phosphor layer 4), it is possible to adjust the proportion of the light irradiated onto area A and area B from the semiconductor light emitting element 2 and adjust the color temperature of the white light emitted from the light emitting device 1. Adjustment may also be performed by horizontally sliding the package 3 without horizontally sliding the phosphor layer 4.

For example, in a light emitting device 1 in a case where the A area 4a of the phosphor layer is a high color temperature area in which the emission-color color temperature is 6500 K, the B area 4b is a low color temperature area in which the emission-color temperature is 2800 K, and the surface areas of areas A and B each have the same surface area as the opening in the package, a pale white light with a color temperature of 6500 K is emitted in a case where the opening in the package 3 is completely covered by the A area 4a of the phosphor layer. In a case where the opening in the package 3 is half covered by the A area 4a and half covered by the B area 4b, white light with a color temperature of about 4600 K which is between intermediate 2800 K and 6500 K is emitted. Meanwhile, if the opening in the package 3 is completely covered by the B area 4b, white light of a light bulb with a color temperature of 2800 K is emitted. Thus, by moving the area of the phosphor layer which covers the opening in the package 3, the color temperature of the emission color can be continuously adjusted, and hence a light emitting device which emits light of the desired color temperature can be provided.

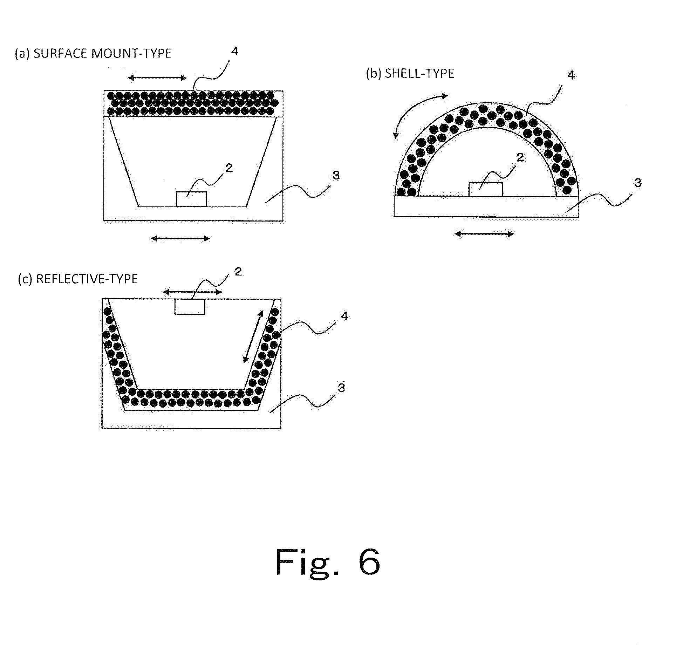

Subsequently, Fig. 6 shows a schematic diagram of another embodiment for the placement of the semiconductor light emitting element 2, the package 3, and the phosphor layer 4.
Fig. 6A shows an embodiment in which the phosphor layer 4 is disposed in the opening of the package 3, which is the embodiment in Fig. 1. Installation is such that the phosphor layer 4 or the package 3 can be moved in the direction of the arrow. The light which is emitted from the semiconductor light emitting element 2 is converted to fluorescent light in the phosphor layer 4 and is emitted outside the device.
Fig. 6B is an embodiment in which the phosphor layer 4 is disposed so as to cover the vicinity of the semiconductor light emitting element 2. The phosphor layer 4 is installed so as to be movable in the direction of the arrow and the package 3 is installed so as to be movable in the direction of the arrow. The light emitted by the semiconductor light emitting element 2 is converted to fluorescent light in the phosphor layer 4 and is emitted outside the device.
Fig. 6C is an embodiment in which the phosphor layer 4 is disposed on the surface of the package 3 and the semiconductor light emitting element 2 is held by a transparent member which is provided in the opening and is disposed so as to emit light downward in the drawing. Installation is such that the phosphor layer 4 can be moved in the arrow direction so as to follow the concave shape of the package 3 and such that the semiconductor light emitting element 2 can be moved in the arrow direction. The light which is emitted by the semiconductor light emitting element 2 is converted to fluorescent light in the phosphor layer 4 and the fluorescent light is reflected by the package 3 comprising the reflective material and is emitted outside the device.

In the embodiment of the present invention which is shown in Fig. 6, the semiconductor light emitting element 2 and the phosphor layer 4 are a distance apart, this distance preferably being at least 0.1 mm, more preferably at least 0.3 mm, even more preferably at least 0.5 mm, and particularly preferably at least 1 mm, and preferably no more than 500 mm, more preferably no more than 300 mm, even more preferably no more than 100 mm, and particularly preferably no more than 50 mm. With such an embodiment, it is possible to prevent weakening of the excitation light per unit surface area of the phosphor as well as phosphor light deterioration. In addition, with such an embodiment, even if the semiconductor light emitting elements and electrodes are connected using a bonding wire, it is possible to suppress any transfer of the heat from the phosphor layer to the vicinity of the bonding wire, and even when cracks are generated in the phosphor layer, it is possible to suppress the transmission of the resulting tensile force to the bonding wire and, as a result, breakage of the bonding wire can be prevented.

### Examples

The present invention will be described in specific terms hereinbelow with reference to Examples, but the present invention is not limited to the following examples, rather, the present invention can be optionally changed within the scope and not departing from the spirit of the present invention. Note that measurement of the particle diameter and particle distribution of the phosphor in this example, measurement of the thickness of the phosphor layer, and measurement of the emission spectrum of the light emitting device were performed using the following method.

### [Measurement of particle diameter and particle distribution]

The volumetric average median diameter Dᵥ₅₀ was obtained from the particle diameter value when the volumetric value, which can be calculated from the intensity of the frequency-based particle size distribution curve, is 50%. The frequency-based particle size distribution curve was obtained by measuring the particle distribution by means of laser diffraction and scatter method.
More specifically, the phosphor was placed in ultrapure water, an ultrasonic nano-dispersion device (made by Kaijo Corporation) as used to set the frequency at 19 KHz and set the intensity of the ultrasonic waves at 5 W, and, after ultrasonic-dispersing the sample for twenty five seconds, a flow cell was used to adjust the initial transmittance on the optical axis to an 88% to 92% range and, after checking that there is no particle cohesion, measurement in a 0.1 µm to 600 µm particle range was performed by means of a laser diffraction particle distribution measurement device (LA-300, made by Horiba, Ltd.).
Note that the volumetric-basis average particle diameter Dᵥ was calculated from the frequency-based particle size distribution curve by means of an equation ∑ (v/d) /∑v, and the number mean diameter Dₙ was calculated from the equation ∑(v/d²)/∑(v/d³) from the frequency-based particle size distribution curve. Note that, here, d is a representative value for each particle channel, and v is the volumetric basis percent for each channel.

### [Measurement of phosphor layer thickness]

The thickness of the phosphor layer was calculated by measuring, using a micrometer, a thickness obtained by combining the phosphor layer with the substrate to which the phosphor layer is applied and measuring the thickness of the substrate after detaching the phosphor layer from the substrate. Note that the difference between the maximum and minimum values for the thickness was calculated by measuring the thickness at four different optional points.

### [Measurement of the light emitting device emission spectrum]

A 20mA current was supplied to a semiconductor light emitting device and the emission spectrum was measured using a fiber multichannel spectroscope (USB2000 by Ocean Optics (integrated wavelength range:200 nm to 1100 nm, light reception system: integrating sphere (1.5-inch diameter)).

### <Investigation via simulation of volume packing ratio and total luminous flux>

### [Example 1]

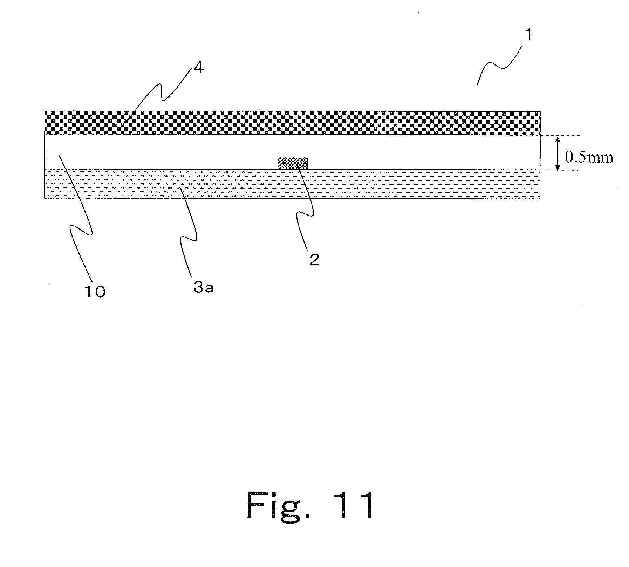

The value of the total luminous flux in a case where the volume packing ratio of the phosphor in the phosphor layer was changed in the light emitting device shown in Fig. 11 was studied via simulation.
More specifically, a light emitting device was fabricated in which a blue-color LED with an emission peak wavelength of 450 nm was used as the semiconductor light emitting element and a phosphor layer obtained by maintaining uniform dispersion of phosphor in the binder resin was used as the phosphor layer, and in which the semiconductor light emitting element and the phosphor layer were disposed spaced apart at a distance of 0.5 mm. As the phosphor contained in the phosphor layer, a CSMS phosphor with a peak wavelength of 514 nm which is represented as Ca₃ (Sc, Mg)₂Si₃O₁₂:Ce (volume median diameter: 12 µm) and a SCASN phosphor with a peak wavelength of 630 nm which is represented as (Sr, Ca) AlSiN₃:Eu (volume median diameter: 10 µm) were used and, as the binder resin which is used in the phosphor layer, a silicone resin (OE6336 by Dow Corning) was used to suitably adjust the phosphor mix ratio such that, irrespective of the volume packing ratio, the color temperature of the light emitted by the light emitting device corresponds to black body radiation with a correlated color temperature of 5500 K. Note that the space between the phosphor layer and semiconductor light emitting element was provided as an air layer.

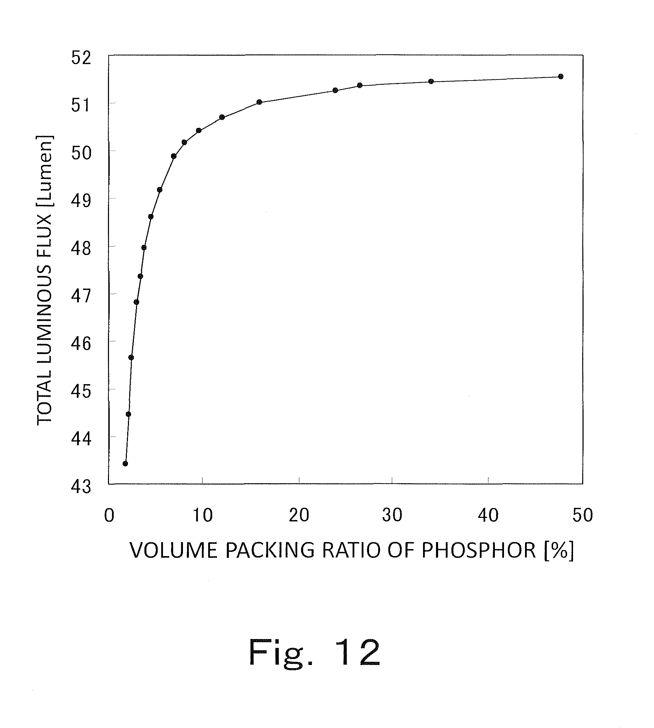

Fig. 12 shows a simulation result for the total luminous flux value in a case where the volume packing ratio of the phosphor in the phosphor layer is changed. As shown in Fig. 12, in a range in which the volume packing ratio is 2% to 7%, the total luminous flux increases rapidly as the volume packing ratio increases, and in the 7% to 15% range, the total luminous flux increases gradually relative to the increase in the volume packing ratio, and at 15% or more and particularly at 20% or more, the total luminous flux barely increases in relation to an increase in the volume packing ratio. That is, if the volume packing ratio is set at 15% or more and particularly at 20% or more, the effect of light absorption by the encapsulating resin can be curbed to the maximum extent, and the emission efficiency of the light emitting device can be improved.

### <Investigation through experimentation of the volume packing ratio and total luminous flux>

### [Example 2]

A light emitting device which comprises a semiconductor light emitting element module and a phosphor layer was fabricated and the total luminous flux was measured.
As the semiconductor light emitting element module, a single 350 µm square InGaN LED chip with a principal emission peak wavelength of 405 nm which is formed using a sapphire substrate was stuck to the cavity bottom face of a 3528 SMD-type PPA resin package by using a transparent diebond paste with a silicone resin base. Following adhesion and after hardening the diebond paste by applying heat for two hours at 150°, an LED chip side electrode and a package side electrode were connected using Au wire with a diameter of 25 µm. Two bonding wires were employed.
The phosphor mix ratio is suitably adjusted such that the content of the phosphor in the phosphor layer is a volume packing ratio of 35% and such that the correlated color temperature of the light emitted by the light emitting device is approximately 5800 K by using, as phosphors, an SBCA phosphor with a peak wavelength of 450 nm which is represented by Sr_{5-b}Ba_{b}(PO₄)₃Cl: Eu (volume median diameter D₅₀ᵥ: 11 µm, Dᵥ/Dₙ = 1.73), a BSON phosphor with a peak wavelength of 535 nm which is represented by Ba₃Si₆O₁₂N₂: Eu (volume median diameter D₅₀ᵥ: 20 µm, Dᵥ/Dₙ = 1.32), and a CASON phosphor with a peak wavelength of 630 nm which is represented by CaAlSi (N,O)₃: Eu (volume median diameter D₅₀ᵥ: 18 µm, D_{v/}Dₙ = 1.50), and, as the binder resin, a polyester urethane resin (the GLS-HF (medium) manufactured by Teikoku printing inks).
Manufacture of the phosphor layer was performed by first introducing a predetermined amount of binder resin and the foregoing three types of phosphor to the same container and, mixing and stirring same using a rotation-revolution mixer "Awatori-Rentarou" (by Thinky Co. Ltd.), coating the mixture a plurality of times on a 100-µm thick PET resin using a screen printer (the ST-310F1G by Okuhara Electric Co. Ltd.) and then solidifying the resin by means of drying by applying heat at 150°C for thirty minutes.
A light emitting device was fabricated in which a phosphor layer is stuck to a light emission face of the semiconductor light emitting element module (package opening) and the upper face of the semiconductor light emitting element and the lower face of the phosphor layer are disposed spaced apart by a distance of 0.85 mm. Note that the space between the phosphor layer and semiconductor light emitting element was provided as an air layer.
The values of various light emission characteristics (chromaticity coordinate (Cx, Cy), correlated color temperature, total luminous flux) which were calculated from the emission spectrum obtained are shown in Table 1.

### [Example 3]

Other than the fact that the content of the phosphor in the phosphor layer is a volume packing ratio of 21%, a light emitting device was fabricated similarly to that of Example 2 and comprising a semiconductor light emitting module and a phosphor layer and the emission spectrum was measured.
The values of various light emission characteristics (chromaticity coordinates (Cx, Cy), correlated color temperature, total luminous flux) which were calculated from the emission spectrum obtained are shown in Table 1.

### [Example 4]

Other than the fact that the content of the phosphor in the phosphor layer is a volume packing ratio of 12%, a light emitting device was fabricated similarly to that of Example 3 and comprising a semiconductor light emitting module and a phosphor layer and the emission spectrum was measured.
The values of various light emission characteristics (chromaticity coordinates (Cx, Cy), correlated color temperature, total luminous flux) which were calculated from the emission spectrum obtained are shown in Table 1. Note that the values of the total luminous flux obtained in Examples 2 to 4 are relative values in a case where the value obtained in Example 4 is 100.

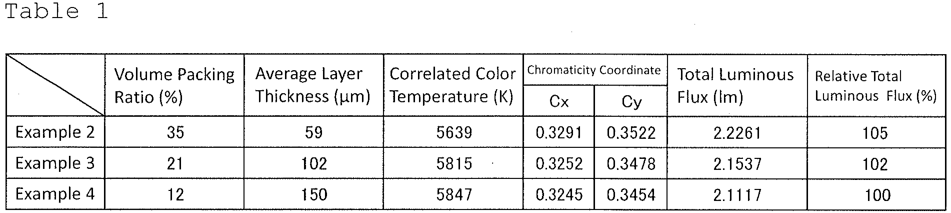

As can be seen from Table 1, it was confirmed that, similarly to the simulation result in Fig. 12, the total luminous flux increases as a result of increasing the volume packing ratio of the phosphor. This is thought to be because, as the volume packing ratio of the phosphor in the phosphor layer increases, the light from the semiconductor light emitting element which is not excited by the phosphor in the phosphor layer can be reduced and because it is possible to reduce the proportion of light absorbed by the encapsulating resin by reducing the amount of encapsulating resin used.
Note that in all of the Examples 2 to 4, the Dᵥ/Dₙ ratio of the phosphor mixture which comprises a SBCA phosphor, BSON phosphor, and CASON phosphor was 2.19. That is, a phosphor layer with a high volume packing ratio can be fabricated because a phosphor mixture with a relatively broad comparative particle distribution is used. Note that the number of peaks in the frequency-based particle size distribution curve for the phosphor mixture is one.
In addition, in the phosphor layer of Example 2, the difference between the maximum and minimum values for the phosphor layer thickness is 4 µm and is about 0.3 times the volume median diameter D₅₀ᵥ (= 13.6µm) of the phosphor mixture, and an extremely uniform phosphor layer can be fabricated.

### <Investigation through experimentation of thickness and total luminous flux of phosphor layer>

### [Example 5]

Other than the fact that the content of the phosphor in the phosphor layer is a volume packing ratio of 24%, that the correlated color temperature is 2800 K, and that there is one application to the PET resin, a light emitting device was fabricated similarly to that of Example 3 and comprising a semiconductor light emitting module and a phosphor layer, and the total luminous flux was measured.

### [Example 6]

Other than the fact that there are two applications to the PET resin, a light emitting device was fabricated similarly to Example 5 and comprising a semiconductor light emitting module and a phosphor layer, and the total luminous flux was measured.

### [Example 7]

Other than the fact that there are three applications to the PET resin, a light emitting device was fabricated similarly to Example 5 and comprising a semiconductor light emitting module and a phosphor layer, and the total luminous flux was measured.

### [Example 8]

Other than the fact that there are four applications to the PET resin, a light emitting device was fabricated similarly to Example 5 and comprising a semiconductor light emitting module and a phosphor layer, and the total luminous flux was measured.

### [Example 9]

Other than the fact that there are five applications to the PET resin, a light emitting device was fabricated similarly to Example 5 and comprising a semiconductor light emitting module and a phosphor layer, and the total luminous flux was measured.

### [Example 10]

Other than the fact that there are six applications to the PET resin, a light emitting device was fabricated similarly to Example 5 and comprising a semiconductor light emitting module and a phosphor layer, and the total luminous flux was measured.

### [Example 11]

Other than the fact that there are seven applications to the PET resin, a light emitting device was fabricated similarly to Example 5 and comprising a semiconductor light emitting module and a phosphor layer and the emission spectrum was measured.

### [Example 12]

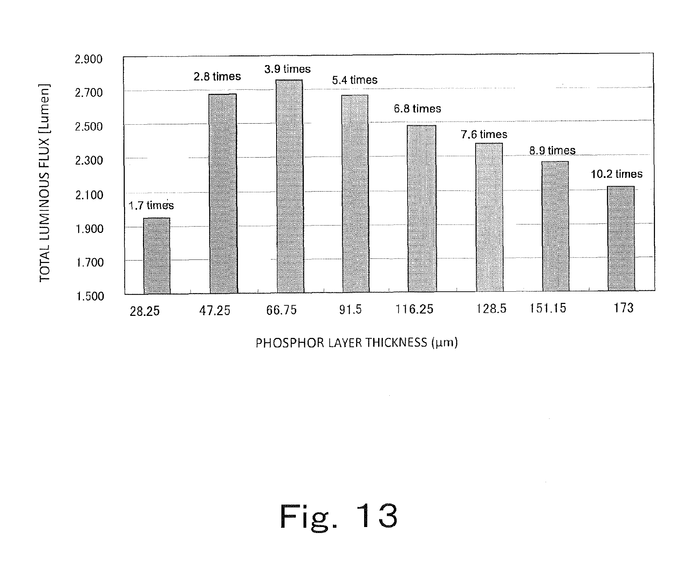

Other than the fact that there are eight applications to the PET resin, a light emitting device was fabricated similarly to Example 5 and comprising a semiconductor light emitting module and a phosphor layer and the emission spectrum was measured.
The results for the emission characteristic value (total luminous flux) and average layer thickness calculated from the emission spectrum obtained are shown in Table 2 and Fig. 13.

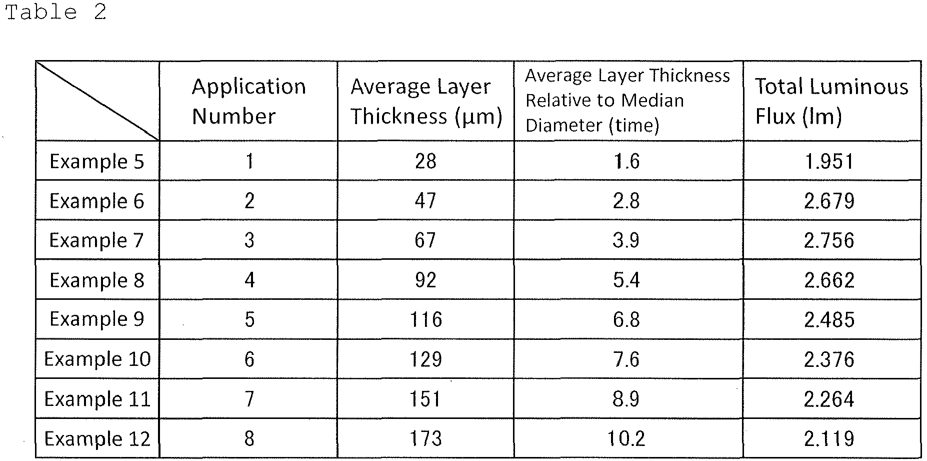

As can be seen from Table 2 and Fig. 13, the total luminous flux rapidly increases as the relative average layer thickness increases in a range where the relative average layer thickness is approximately one to four times the median diameter, however, in the approximately four to ten times range, the total luminous flux gradually decreases as the relative average layer thickness increases. This is considered to be because the emission amount increases as the amount of phosphor used increases in the approximately one to four times range, however, in the approximately four to ten times range, the increase in self-absorption and/or cascade excitation due to the increase in the amount of phosphor used is larger as a contributing factor than the increase in the emission amount due to the increase in the amount of phosphor used.

### INDUSTRIAL APPLICABILITY

The present invention can be employed in fields where light is used, and can suitably be used in indoor and outdoor lighting and so on, for example. Note that, although the present invention was described by taking specific aspects by way of example, it is easily understood by a person skilled in the art that modifications to the embodiments can be made without departing from the scope of the present invention.

### EXPLANATION OF REFERENCE NUMERALS

- 1: Light emitting device
- 2: Semiconductor light emitting element
- 3: Package
- 3a: wiring substrate
- 4: Phosphor layer
- 4a: Area A
- 4b: Area B
- 5: Transparent substrate
- 6a: First light-emitting member
- 6b: Second light-emitting member
- 6c: Third light-emitting member
- 7a: First phosphor
- 7b: Second phosphor
- 8: Sliding direction
- 9: Bandpass filter
- 10: Air layer

## Claims

1. A light emitting device which is configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element, by being excited by the light emitted by the semiconductor light emitting element,
(iii) the phosphor layer includes the phosphor at a volume packing ratio of at least 15%, and
(iv) a ratio (Dᵥ/Dₙ) between a volumetric basis average particle diameter Dᵥ and a number mean diameter Dₙ of the phosphor in the phosphor layer is 1.2 or more and 25 or less.

2. The light emitting device according to claim 1,
wherein the phosphor layer has a thickness of two or more times and ten or less times a volume median diameter D₅₀ᵥ of the phosphor.

3. The light emitting device according to claim 1 or 2, wherein the volume median diameter D₅₀ᵥ of the phosphor is 2 µm or more and 30 µm or less.

4. A light emitting device which is configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element, by being excited by the light emitted by the semiconductor light emitting element,
(iii) the phosphor layer has a thickness of two or more times and ten or less times a volume median diameter D₅₀ᵥ of the phosphor, and
(iv) a ratio (Dᵥ/Dₙ) between a volumetric basis average particle diameter Dᵥ and a number mean diameter Dₙ of the phosphor in the phosphor layer is 1.2 or more and 25 or less.

5. The light emitting device according to any one of claims 1 to 4,
wherein a difference between a maximum thickness and a minimum thickness of the phosphor layer is no more than a volume median diameter D₅₀ᵥ of the phosphor layer.

6. A light emitting device which is configured comprising a semiconductor light emitting element and a phosphor layer, wherein
(i) the semiconductor light emitting element emits light of a wavelength of 350 nm or more and 520 nm or less,
(ii) the phosphor layer includes a phosphor which is capable of emitting light of a longer wavelength than the light emitted by the semiconductor light emitting element, by being excited by the light emitted by the semiconductor light emitting element,
(iii) a ratio (Dᵥ/Dₙ) between a volumetric basis average particle diameter Dᵥ and a number mean diameter Dₙ of the phosphor in the phosphor layer is 1.2 or more and 25 or less, and
(iv) a difference between a maximum thickness and a minimum thickness of the phosphor layer is no more than a volume median diameter D₅₀ᵥ of the phosphor layer.

7. The light emitting device according to any one of claims 1 to 6,
wherein the phosphor layer contains a binder resin.

8. The light emitting device according to any one of claims 1 to 7,
wherein the phosphor has overlapping wavelength ranges between an emission wavelength range in an emission spectrum and an excitation wavelength range in an excitation spectrum.

9. The light emitting device according to any one of claims 1 to 8,
wherein the phosphor includes a first phosphor capable of emitting first light of a longer wavelength than the light emitted by the semiconductor light emitting element, by being excited by the light emitted by the semiconductor light emitting element, and a second phosphor which is capable of emitting second light of a longer wavelength than the first light, by being excited by the light emitted by the semiconductor light emitting element.

10. The light emitting device according to claim 9,
wherein the second phosphor is a phosphor which is capable of emitting second light of a longer wavelength than the first light by being excited by the first light.

11. The light emitting device according to claim 9 or 10,
wherein a difference between a value of the D₅₀ᵥ of the first phosphor and a value of the D₅₀ᵥ of the second phosphor is at least 1 µm.

12. The light emitting device according to any one of claims 9 to 11,
wherein the phosphor layer includes a first light emitting member and a second light emitting member, wherein
(i) the first light emitting member contains the first phosphor,
(ii) the second light emitting member contains the second phosphor, and
(iii) the first light emitting member and the second light emitting member in the phosphor layer are formed as separate members in a direction perpendicular to a thickness direction of the phosphor layer.

13. The light emitting device according to any one of claims 1 to 12,
wherein a distance between the semiconductor light emitting element and the phosphor layer is 0.1 mm or more and 500 mm or less.

14. The light emitting device according to any one of claims 1 to 13, further comprising, on the light emission side of the light emitting device of the phosphor layer, a bandpass filter which reflects at least a portion of the light emitted by the semiconductor light emitting element and transmits at least a portion of the light emitted by the phosphor.

15. The light emitting device according to any one of claims 1 to 14, further comprising, on the semiconductor light emitting element side of the phosphor layer, a bandpass filter which transmits at least a portion of the light emitted by the semiconductor light emitting element and reflects at least a portion of the light emitted by the phosphor.

16. The light emitting device according to any one of claims 1 to 15,
wherein the phosphor layer contains an area A and an area B with different emission spectra, and
a proportion of light which is irradiated onto the area A and area B from the semiconductor light emitting element can be adjusted by the phosphor layer or the semiconductor light emitting element moving in a direction perpendicular to a thickness direction of the phosphor layer.
